(19) Europäisches Patentamt
European Patent Office
Office européen des brevets

(11) EP 2 568 774 B1

(12) # EUROPEAN PATENT SPECIFICATION

(45) Date of publication and mention of the grant of the patent:
**27.02.2019 Bulletin 2019/09**

(21) Application number: **12183531.8**

(22) Date of filing: **07.09.2012**

(51) Int Cl.:
***H05B 33/20*** (2006.01) ***H01L 51/00*** (2006.01)
***C08G 61/12*** (2006.01) ***H01L 51/50*** (2006.01)
***H01L 51/52*** (2006.01)

(54) **Polymer and organic light-emitting device including the same**

Polymer und organische lichtemittierende Vorrichtung damit

Polymère et dispositif électroluminescent organique l'incluant

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.09.2011 KR 20110092224**

(43) Date of publication of application:
**13.03.2013 Bulletin 2013/11**

(73) Proprietor: **Samsung Electronics Co., Ltd.**
**Suwon-si, Gyeonggi-do, 443-742 (KR)**

(72) Inventors:
- **Choi, Hyeon-ho**
**449-712 Gyeonggi-do (KR)**
- **Son, Jhun-mo**
**449-712 Gyeonggi-do (KR)**
- **Kang, Ho-suk**
**449-712 Gyeonggi-do (KR)**
- **Yang, Hye-yeon**
**449-712 Gyeonggi-do (KR)**
- **Jung, Yong-sik**
**449-712 Gyeonggi-do (KR)**

(74) Representative: **Elkington & Fife LLP**
**Prospect House**
**8 Pembroke Road**
**Sevenoaks, Kent TN13 1XR (GB)**

(56) References cited:
**US-A1- 2007 173 633**
**US-A1- 2007 278 455**
**US-A1- 2010 133 992**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 568 774 B1

## Description

BACKGROUND OF THE INVENTION

The present disclosure relates to a polymer and an organic light-emitting device including the polymer.

Organic light-emitting devices are self-emitting devices that are lightweight, can be easily manufactured using a relatively small number of components, and provide high-quality images with a wide viewing angle. Furthermore, organic light-emitting devices provide high color purity, accurately realize moving pictures, have low power consumption, and are operated at a low voltage. Due to these characteristics, organic light-emitting devices are suitable for mobile electronic devices.

A typical organic light-emitting device may have a structure in which an anode, a first layer, and a cathode are sequentially stacked on a substrate, wherein the first layer may include a hole transport layer (HTL), an emission layer (EML), and an electron transport layer (ETL).

When a current is applied between the anode and the cathode, holes injected from the anode move to the EML via the HTL, and electrons injected from the cathode move to the EML via the ETL. The holes and electrons recombine in the EML to generate excitons. The excitons radioactively decay to emit light having a wavelength corresponding to the band gap of a material.

Materials used to form the first layer may be classified as either vacuum-depositable materials or solution-coatable materials according to the method of forming the first layer. The solution-coatable materials should be miscible with a solvent to form a composition that is coatable on a substrate by a known solution application method, such as inkjet printing, screen printing, or spin coating.

US 2007/0173633 discloses electroluminescent polymers including repeating units of Formula (1) and Formula (2) below and an organic electroluminescent device including an organic layer having the electroluminescent polymer:

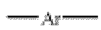

(1)

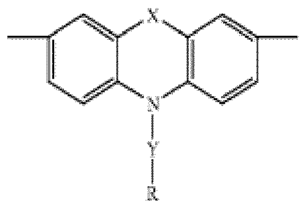

(2)

.

SUMMARY OF THE INVENTION

Provided is a polymer having a novel structure.

Provided is an organic light-emitting device (OLED) including the polymer.

Additional aspects will be set forth in part in the description which follows and, in part, will be apparent from the description, or may be learned by practice of the presented embodiments.

According to the present invention, a polymer includes m repeating units, wherein an $n^{th}$ repeating unit of the m repeating units is a first repeating unit represented by Formula 1 below,

Wherein, when estimated by density functional theory using B3LYP exchange functional and 6-31+G(d) basis set, at least one of a first dihedral angle between an $A_1$ ring of the $n^{th}$ repeating unit and a first aromatic ring of an $(n-1)^{th}$ repeating unit and a second dihedral angle between an $A_2$ ring of the $n^{th}$ repeating unit and a second aromatic ring of a $(n+1)^{th}$ repeating unit is equal to or greater than an angle of $\chi_{50\%}$ represented by Equation 1:

Formula 1

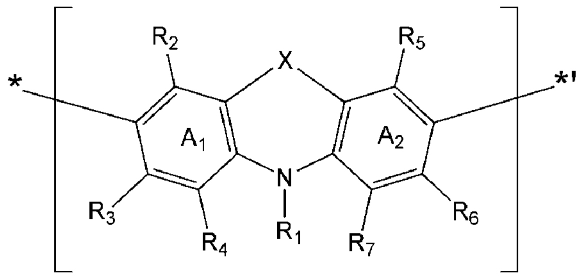

Equation 1

$$\chi_{50\%} = A + B(\varphi + 4\theta)$$

wherein the first aromatic ring is bound to the $A_1$ ring by a single bond;
the second aromatic ring is bound to the $A_2$ ring by a single bond;
$R_1$ to $R_7$ of Formula 1 are each independently one of a hydrogen atom, a deuterium atom, a halogen atom, a hydroxyl group, a cyano group, a nitro group, a carboxyl group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{60}$ cycloalkyl group, a substituted or unsubstituted $C_3$-$C_{60}$ cycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_2$-$C_{60}$ heteroaryl group, $-N(Q_1)(Q_2)$, and $-Si(Q_3)(Q_4)(Q_5)$, wherein $Q_1$ to $Q_5$ are each independently a hydrogen atom, a deuterium atom, a halogen atom, a hydroxyl group, a cyano group, a nitro group, a carboxyl group, a $C_1$-$C_{60}$ alkyl group, a $C_2$-$C_{60}$ alkenyl group, a $C_2$-$C_{60}$ alkynyl group, a $C_3$-$C_{60}$ cycloalkyl group, a $C_6$-$C_{60}$ aryl group, or a $C_2$-$C_{60}$ heteroaryl group;
X of Formula 1 is a single bond, or a linker including carbon or a Group 16 element;
m is an integer from 2 to 1000;
n is a variable of from 2 to m-1;
A of Formula 1 is 26.03, and B is 0.0445;
$\varphi$ of Equation 1 is an angle between the $A_1$ ring and $A_2$ ring of Formula 1, as illustrated in Formula 1-1 below; and
$\theta$ of Equation 1 is an angle between a first imaginary line extending from a bond between the $A_1$ ring and a $A_3$ ring of Formula 1 in a direction close to nitrogen of the $A_3$ ring and a second imaginary line extending from a bond between the $A_2$ ring and $A_3$ ring in a direction close to the nitrogen of the $A_3$ ring, as illustrated in Formula 1-2 below:

Formula 1-1

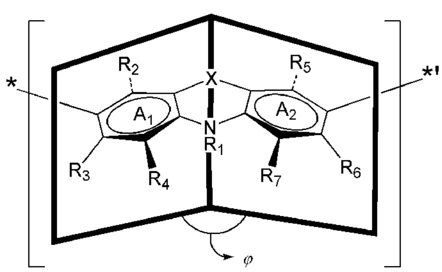

Formula 1-2

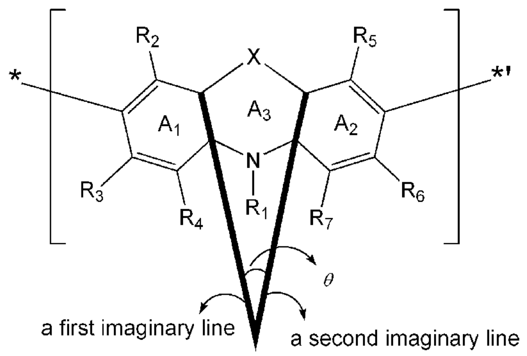


wherein the polymer further comprises a second repeating unit represented by Formula 5A, 5B, 5C, 5D, or 5E below:

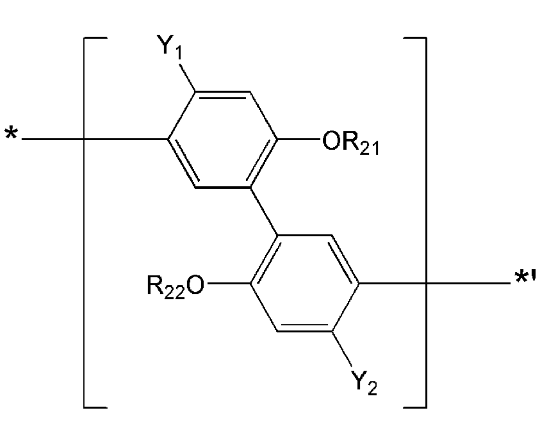

Formula 5A

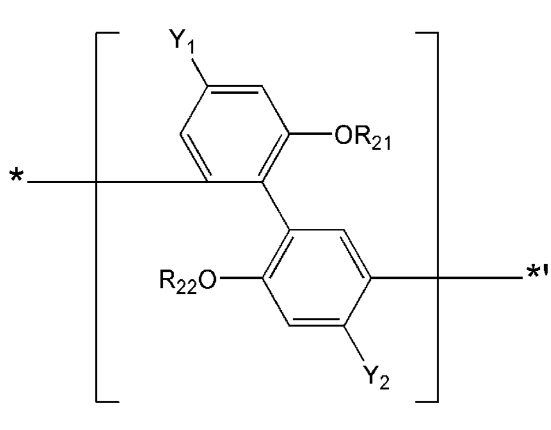

Formula 5B

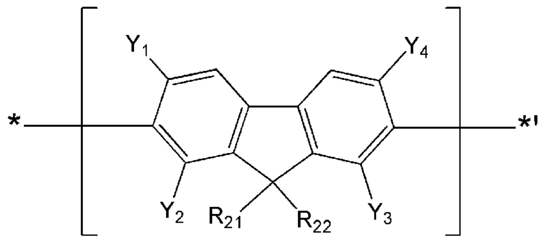

Formula 5C

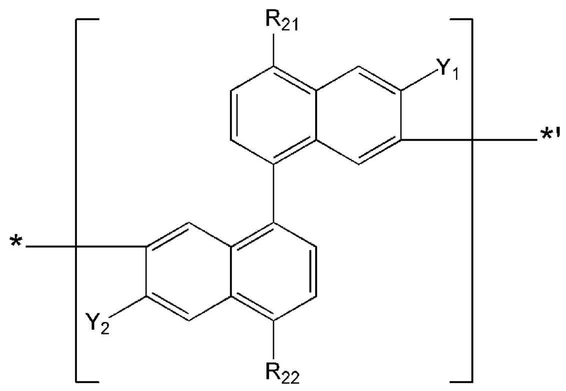

Formula 5D

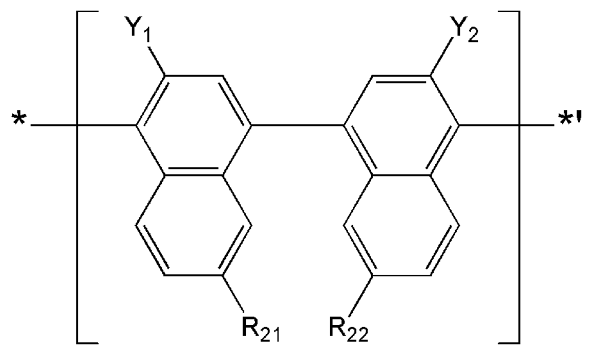

Formula 5E

wherein, in Formulae 5A to 5E, $R_{21}$ and $R_{22}$ are each independently a substituted or unsubstituted $C_1$-$C_{60}$ alkyl group; and

$Y_1$ to $Y_4$ are each independently a hydrogen atom, a substituted or unsubstituted $C_1$-$C_{60}$ alkyl group, or a substituted or unsubstituted $C_1$-$C_{60}$ alkoxy group, or a combination thereof.

The polymer may be used as a phosphorescent host in an emission layer of an organic light-emitting device.

According to another aspect of the present invention, an organic light-emitting device includes: a substrate; a first electrode; a second electrode; and a first layer disposed between the first electrode and the second electrode, the first layer including the polymer.

BRIEF DESCRIPTION OF THE DRAWINGS

These and/or other aspects will become apparent and more readily appreciated from the following description of the embodiments, taken in conjunction with the accompanying drawings in which:

FIG. 1 is a schematic sectional view of an organic light-emitting device according to an embodiment of the present disclosure;

FIG. 2 is a graph of photoluminescence (PL) spectrum data of a polymer A;

FIG. 3 is a graph of electroluminescence (EL) spectrum data of an organic light-emitting devices of Examples 1 and 2;

FIG. 4 is a graph of voltage versus current density of the organic light-emitting device of Example 1 (4 measurement times);

FIG. 5 is a graph of voltage versus current efficiency of the organic light-emitting device of Example 1 (4 measurement times);

FIG. 6 is a graph of voltage versus luminance of the organic light-emitting device of Example 1 (4 measurement times);

FIG. 7 is a graph of voltage versus current density of the organic light-emitting device of Example 2 (2 measurement times);

FIG. 8 is a graph of voltage versus current density of the organic light-emitting device of Example 2 (2 measurement

times);

FIG. 9 is a graph of voltage versus luminance of the organic light-emitting device of Example 2 (2 measurement times);

FIG. 10 is a graph of electroluminescence (EL) spectra of an organic light-emitting device of Example 3;

FIG. 11 is graphs of voltage versus current density and voltage versus luminance of the organic light-emitting device of Example 3; and

FIG. 12 is a graph of current density versus current efficiency of the organic light-emitting device of Example 3.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

According to an exemplary embodiment of the present disclosure, a polymer includes m repeating units, wherein an $n^{th}$ repeating unit of the m repeating units is a first repeating unit represented by Formula 1 below:

Formula 1

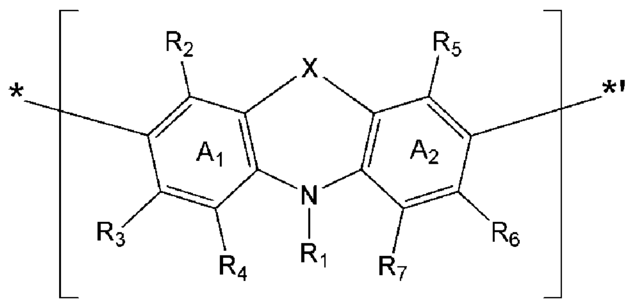

In Formula 1, m indicates the number of repeating units of the polymer, which may be an integer from 2 to 1000, and in some embodiments, may be an integer from 10 to 200;

n is a variable from 2 to m-1; and

X may be a single bond, or a linker including carbon or a Group 16 element.

For example, X of Formula 1 may be selected from among a linker with carbon, a single bond, a linker with -O-, a linker with -S-, a linker with-Se-, but is not limited thereto.

At least one of a first dihedral angle between an $A_1$ ring of the $n^{th}$ repeating unit and a first aromatic ring of an $(n-1)^{th}$ repeating unit and a second dihedral angle between an $A_2$ ring of the $n^{th}$ repeating unit and a second aromatic ring of a $(n+1)^{th}$ repeating unit may be equal to or greater than an angle of $\chi_{50\%}$ represented by Equation 1:

Equation 1

$$\chi_{50\%} = A + B(\varphi + 4\theta)$$

In Equation 1, A is 26.03, and B is 0.0445.

In Equation 1, $\varphi$ is an angle between the $A_1$ ring and $A_2$ ring of Formula 1, as illustrated in Formula 1-1 below, and $\theta$ is an angle between a first imaginary line extending from a bond between the $A_1$ ring and an $A_3$ ring of Formula 1 in a direction close to nitrogen of the $A_3$ ring and a second imaginary line extending from a bond between the $A_2$ ring and $A_3$ ring in a direction close to the nitrogen of the $A_3$ ring, as illustrated in Formula 1-2 below:

Formula 1-1

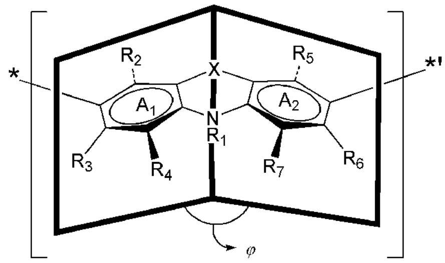

Formula 1-2

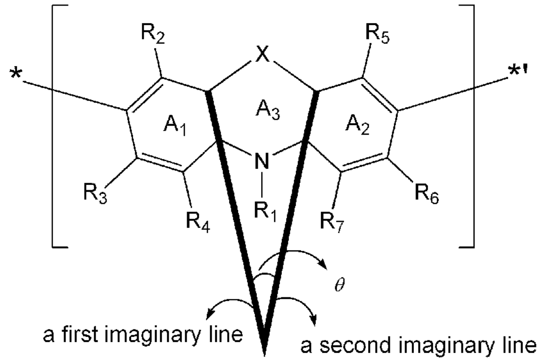


Formula 1-1 and Formula 1-2 are for describing $\varphi$ and $\theta$ of Equation 1 with imaginary lines (first and second imaginary lines) and planes (of Formula 1-1 with the $A_1$ and $A_2$ rings thereon).

A first aromatic ring in the (n-1)$^{th}$ repeating unit is bound to the $A_1$ ring of the n$^{th}$ repeating unit via a single bond, and a second aromatic ring in the (n+1)$^{th}$ repeating unit is bound to the $A_2$ ring of the n$^{th}$ repeating unit via a single bond.

In Formula 1, $\varphi$ and $\theta$ may be dependent on X.

For example, X may be a linker that includes carbon represented by Formula 2.

Formula 2

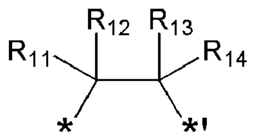

$R_{11}$ to $R_{14}$ of Formula 2 are each independently a hydrogen atom, a deuterium atom, a halogen atom, a hydroxyl group, a cyano group, a nitro group, a carboxyl group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{60}$ cycloalkyl group, a substituted or unsubstituted $C_3$-$C_{60}$ cycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, or a substituted or unsubstituted $C_2$-$C_{60}$ heteroaryl group.

In some embodiments, $R_{11}$ to $R_{14}$ of Formula 2 are each independently a hydrogen atom, a deuterium atom, a halogen atom, a hydroxyl group, a cyano group, a nitro group, a carboxyl group, a substituted or unsubstituted $C_1$-$C_{20}$ alkyl group, or a substituted or unsubstituted $C_1$-$C_{20}$ alkoxy group, but are not limited thereto.

For example, $R_{11}$ to $R_{14}$ of Formula 2 may be each independently at least one of a hydrogen atom; a deuterium atom; F; Cl; a hydroxyl group; a cyano group; a nitro group; a carboxyl group; a methyl group; an ethyl group; a propyl group; an i-propyl group; a butyl group; an i-butyl group; a t-butyl group; a pentyl group; a hexyl group; a heptyl group; an octyl group; a 2-ethylhexyl group; a nonyl group; a decyl group; a 3,7-dimethyloctyl group; a methyl group, an ethyl group, a propyl group, an i-propyl group, a butyl group, an i-butyl group, a t-butyl group, a pentyl group, a hexyl group, a heptyl group, an octyl group, a 2-ethylhexyl group, a nonyl group, a decyl group, and a 3,7-dimethyloctyl that are each substituted with at least one of a deuterium atom, F, Cl, a hydroxyl group, a cyano group, a nitro group, and a carboxyl group; a methoxy group; an ethoxy group; a propyloxy group; an i-propyloxy group; a butoxy group; an i-butoxy group; a t-butoxy group; a pentyloxy group; a hexyloxy group; a heptyloxy group; an octyloxy group; a 2-ethylhexyloxy group; a nonyloxy group; a decyloxy group; a 3,7-dimethyloctyloxy group; and a methoxy group, an ethoxy group, a propyloxy group, an i-propyloxy group, a butoxy group, a i-butoxy group, a t-butoxy group, a pentyloxy group, a hexyloxy group, a heptyloxy group, an octyloxy group, a 2-ethylhexyloxy group, a nonyloxy group, a decyloxy group, and a 3,7-dimethyloctyloxy group that are each substituted with at least one of a deuterium atom, F, Cl, a hydroxyl group, a cyano group, a nitro group, and a carboxyl group.

For example, in Formula 2, $R_{11}$ to $R_{14}$ may be all hydrogen atoms.

When X of Formula 1 is a linker represented by Formula 2 above, that $158.37 \leq \varphi \leq 160.37$ (for example, $158.87 \leq \varphi \leq 159.87$), $32.52 \leq \theta \leq 34.52$ (for example, $33.02 \leq \theta \leq 34.02$), and $38.00 \leq \chi_{50\%} \leq 40.00$ (for example,

$38.50 \leq \chi_{50\%} \leq 39.50$) may be satisfied. In some other embodiments, when X of Formula 1 is a linker represented by Formula 2, that $159.17 \leq \varphi \leq 159.57$, $33.32 \leq \theta \leq 33.72$, and $38.80 \leq \chi_{50\%} \leq 39.20$ may be satisfied.

When X of Formula 1 is a single bond, that $\varphi = 180.00$; $-34.45 \leq \theta \leq -32.45$ (for example, $-33.95 \leq \theta \leq -32.95$), and $27.00 \leq \chi_{50\%} \leq 29.00$ (for example, $27.50 \leq \chi_{50\%} \leq 28.50$) may be satisfied. In some other embodiments, when X of Formula 1 is a single bond, that $\varphi = 180.00$, $-33.65 \leq \theta \leq -33.25$, and $27.80 \leq \chi_{50\%} \leq 28.20$ may be satisfied.

When X of Formula 1 is a linker represented by -O-, that $167.18 \leq \varphi \leq 169.18$ (for example, $167.68 \leq \varphi \leq 168.68$), $-2.81 \leq \theta \leq -0.81$ (for example, $-2.31 \leq \theta \leq -1.31$), and $32.00 \leq \chi_{50\%} \leq 34.00$ (for example, $32.50 \leq \chi_{50\%} \leq 33.50$) may be satisfied. In some other embodiments, when X of Formula 1 is a linker represented by -O-, that $167.98 \leq \chi \leq 168.38$, $-2.01 \leq \theta \leq -1.61$, and $32.80 \leq \chi_{50\%} \leq 33.20$ may be satisfied.

When X of Formula 1 is a linker represented by -S-, that $149.27 \leq \varphi \leq 151.27$ (for example, $149.77 \leq \varphi \leq 150.77$), $10.01 \leq \theta \leq 12.01$ (for example, $10.51 \leq \theta \leq 11.51$), and $34.00 \leq \chi_{50\%} \leq 36.00$ (for example, $34.50 \leq \chi_{50\%} \leq 35.50$) may be satisfied. In some other embodiments, when X of Formula 1 is a linker represented by -S-, that $150.07 \leq \varphi \leq 150.47$, $10.81 \leq \theta \leq 11.21$, and $34.80 \leq \chi_{50\%} \leq 35.20$ may be satisfied.

When X of Formula 1 is a linker represented by -Se-, that $145.94 \leq \varphi \leq 147.94$ (for example, $146.44 \leq \varphi \leq 147.44$), $14.46 \leq \theta \leq 16.46$ (for example, $14.96 \leq \theta \leq 15.96$), and $34.00 \leq \chi_{50\%} \leq 36.00$ (for example, $34.50 \leq \chi_{50\%} \leq 35.50$) may be satisfied. In some other embodiments, when X of Formula 1 is a linker represented by -Se-, that $146.74 \leq \varphi \leq 147.14$, $15.26 \leq \theta \leq 15.66$, and $34.80 \leq \chi_{50\%} \leq 35.20$ may be satisfied.

For example, $\varphi$, $\theta$, and $\chi_{50\%}$ of Equation 1 may have the following values in Table 1 depending on X, but are not limited thereto:

Table 1

| X | $\varphi$(°) | $\theta$(°) | $\chi_{50\%}$(°) |
|---|---|---|---|
| Linker represented by Formula 2 (where $R_{11}$ to $R_{14}$ are all hydrogen atoms.) | 159.37 | 33.52 | 39.08 |
| single bond | 180.00 | -33.45 | 28.08 |
| -O- | 168.18 | -1.81 | 33.19 |
| -S- | 150.27 | 11.01 | 34.67 |
| -Se- | 146.94 | 15.46 | 35.32 |

$\varphi$ and $\theta$ of Equation 1 may be calculated by the application of density functional theory (DFT) with the B3LYP/6-31+G(D) basis set to a unit compound where $R_1$ to $R_7$ are all hydrogen atoms (i.e.,

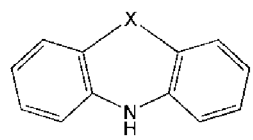

),

and $\chi_{50\%}$ may be calculated using time-dependent density functional theory (TDDFT). TDDFT is a quantum mechanical theory used to investigate the properties and dynamics of body systems in the presence of time-dependent potentials, such as electric or magnetic fields, which has been suggested to describe the time dependency that is unexplainable with DFT, which is one of the quantum computation theory methods, and may be applicable in describing the effects of such time-dependent electric or magnetic fields. TDDEF may be used for a calculation of the quantum state (energy, structure, etc.) of a target system in an excited state based on linear response theory to obtain absorption/emission spectra, or for interpretation of the excited state information.

When at least one of the first dihedral angle and the second dihedral angle of the polymer including the first repeating unit of Formula 1 above is equal to or greater than an angle of $\chi_{50\%}$ defined by Equation 1 above, the polymer may have a high triplet state energy, for example, that is suitable for use as a phosphorescent host in an organic light-emitting device. Therefore, the polymer including the first repeating unit of Formula 1 may be used as a phosphorescent host of an organic light-emitting device.

An increased conjugation length in a polymer for use as an organic semiconductor may lead to a higher charge mobility, but at the same time, to a reduction in excited state energy of the polymer, which is not conducive to use as a phosphorescent host. Therefore, for availability as a phosphorescent host, designing a polymer with a conjugation structure that ensures both an appropriate range of excited state energies as a phosphorescent host and no reduction in charge mobility is required.

However, essential measures and requirements for designing a polymer with a conjugation structure appropriate as a phosphorescent host have not been revealed yet. The inventors of the present disclosure found that with a polymer designed to include the first repeating unit of Formula 1 above in which at least one of the first dihedral angle and the second dihedral angle is equal to or greater than an angle of $\chi_{50\%}$ defined by Equation 1, an original conjugation length of the polymer may be maintained, and at the same time, a conjugation structure breakage effect in some regions of the polymer may be obtained due to tilting of the $n^{th}$ repeating unit with respect to the $n\text{-}1^{th}$ repeating unit and/or to the $n+1^{th}$ repeating unit of the polymer, which may maintain both the charge mobility and the excited state energy of the polymer high. Accordingly, the polymer may have a high triplet state energy, and thus may be available as a phosphorescent host of an organic light-emitting device.

As described above, a polymer having an effective triplet state energy may be designed using monomers that allow the target polymer to have a smallest dihedral angle (refer to the definition above) that is equal to or greater than $\chi_{50\%}$ defined by Equation 1. Analysis of $\chi_{50\%}$ and dihedral angles of a polymer has a wide range of applications, for example, in predicting whether the polymer may provide an effective triplet state energy (i.e., its availability as a phosphorescent host of an organic light-emitting device).

Evaluation of the first and second dihedral angle angles of the polymer is possible via computational simulations of electronic structures. For example, the first dihedral angle and the second dihedral angle of a target polymer are predictable using DFT with the exchange-correlation potential functional (xc-functional) of B3LYP using a 6-31+G(D) basis set.

Dihedral angles of polymers may be experimentally measured using x-ray diffraction analysis. For example, a first dihedral angle of a polymer A below may be practically measured by X-ray diffraction analysis on carbazole having an - $OC_8H_{17}$ substituted phenyl group as illustrated in Formula A(1) below.

<Polymer A: Polymer consisting of the following repeating unit>

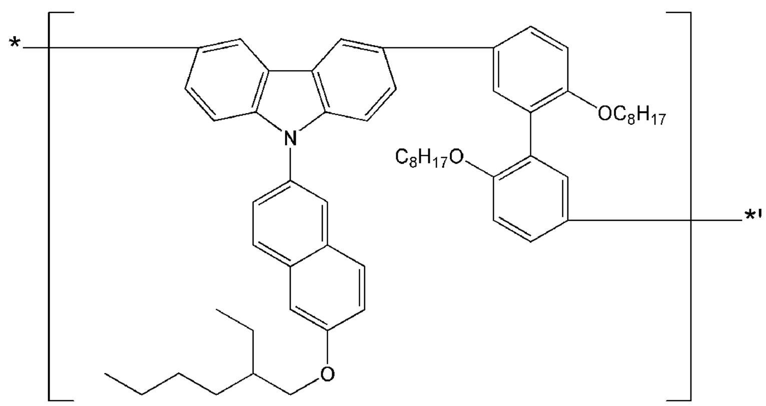

Formula A(1)

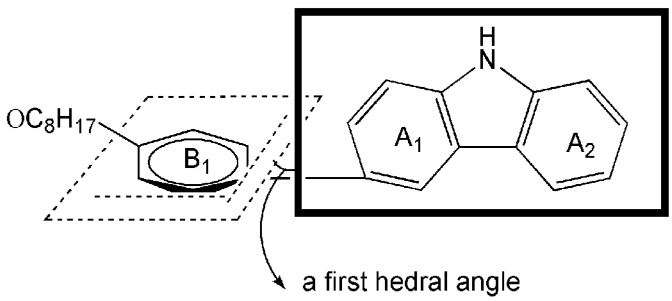


The triplet state energy of the polymer may be measured by analysis of peaks from photoluminescence (PL) spectra on a mixture of the polymer and toluene contained in a quartz cell.

In Formula 1, $R_1$ to $R_7$ are each independently one of a hydrogen atom, a deuterium atom, a halogen atom, a hydroxyl group, a cyano group, a nitro group, a carboxyl group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or

unsubstituted $C_1$-$C_{60}$ alkoxy group, a substituted or unsubstituted $C_3$-$C_{60}$ cycloalkyl group, a substituted or unsubstituted $C_3$-$C_{60}$ cycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_2$-$C_{60}$ heteroaryl group, $-N(Q_1)(Q_2)$, and $-Si(Q_3)(Q_4)(Q_5)$, wherein $Q_1$ to $Q_5$ are each independently a hydrogen atom, a deuterium atom, a halogen atom, a hydroxyl group, a cyano group, a nitro group, a carboxyl group, a $C_1$-$C_{60}$ alkyl group, a $C_2$-$C_{60}$ alkenyl group, a $C_2$-$C_{60}$ alkynyl group, a $C_3$-$C_{60}$ cycloalkyl group, a $C_6$-$C_{60}$ aryl group, or a $C_2$-$C_{60}$ heteroaryl group.

For example, $R_1$ to $R_7$ in Formula 1 may be each independently one of a hydrogen atom, a deuterium atom, a halogen atom, a hydroxyl group, a cyano group, a nitro group, a carboxyl group, a substituted or unsubstituted $C_1$-$C_{20}$ alkyl group, a substituted or unsubstituted $C_1$-$C_{20}$ alkoxy group, a substituted or unsubstituted phenyl group, a substituted or unsubstituted pentalenyl group, a substituted or unsubstituted indenyl group, a substituted or unsubstituted naphthyl group, a substituted or unsubstituted azulenyl group, a substituted or unsubstituted heptalenyl group, a substituted or unsubstituted indacenyl group, a substituted or unsubstituted acenaphthyl group, a substituted or unsubstituted fluorenyl group, a substituted or unsubstituted phenalenyl group, a substituted or unsubstituted phenanthryl group, a substituted or unsubstituted anthryl group, a substituted or unsubstituted fluoranthenyl group, a substituted or unsubstituted triphenylenyl group, a substituted or unsubstituted pyrenyl group, a substituted or unsubstituted chrysenyl group, a substituted or unsubstituted naphthacenyl group, a substituted or unsubstituted picenyl group, a substituted or unsubstituted perylenyl group, a substituted or unsubstituted pentaphenyl group, a substituted or unsubstituted hexacenyl group, a substituted or unsubstituted pyrrolyl group, a substituted or unsubstituted pyrazolyl group, a substituted or unsubstituted imidazolyl group, a substituted or unsubstituted imidazolinyl group, a substituted or unsubstituted imidazopyridinyl group, a substituted or unsubstituted imidazopyrimidinyl group, a substituted or unsubstituted pyridinyl group, a substituted or unsubstituted pyrazinyl group, a substituted or unsubstituted pyrimidinyl group, a substituted or unsubstituted indolyl group, a substituted or unsubstituted purinyl group, a substituted or unsubstituted quinolinyl group, a substituted or unsubstituted phthalazinyl group, a substituted or unsubstituted indolizinyl group, a substituted or unsubstituted naphthyridinyl group, a substituted or unsubstituted quinazolinyl group, a substituted or unsubstituted cinnolinyl group, a substituted or unsubstituted indazolyl group, a substituted or unsubstituted carbazolyl group, a substituted or unsubstituted phenazinyl group, a substituted or unsubstituted phenanthridinyl group, a substituted or unsubstituted chromenyl group, a substituted or unsubstituted benzofuranyl group, a substituted or unsubstituted thiophenyl group, a substituted or unsubstituted benzothiophenyl group, a substituted or unsubstituted isothiazolyl group, a substituted or unsubstituted benzoimidazolyl group, and a substituted or unsubstituted isoxazolyl group.

For example, in Formula 1, $R_2$ to $R_7$ may be hydrogen atoms, and $R_1$ may be represented by Formula 3A, 3B, 3C, 3D, 3E, 3F, 3G, 3H, or 3I.

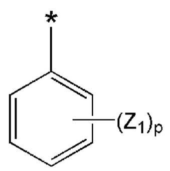

Formula 3A

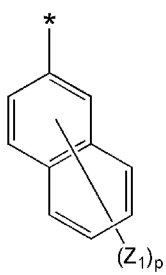

Formula 3B

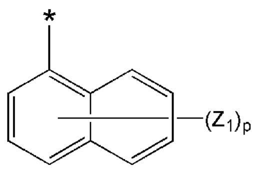

Formula 3C

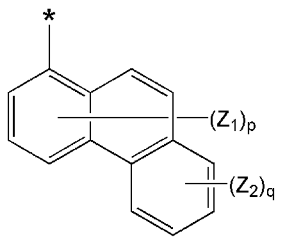

Formula 3D

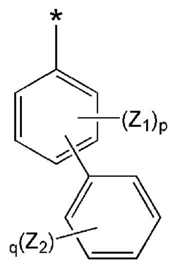

Formula 3E

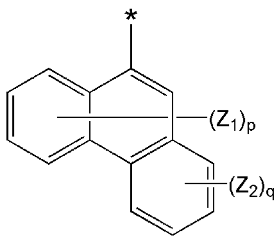

Formula 3F

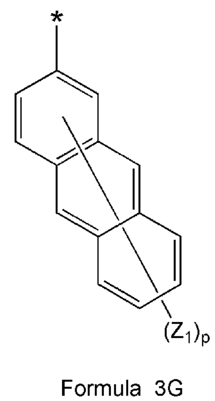

Formula 3G

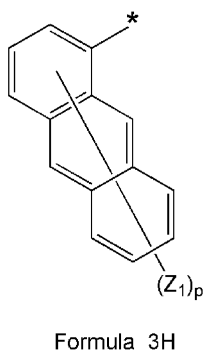

Formula 3H

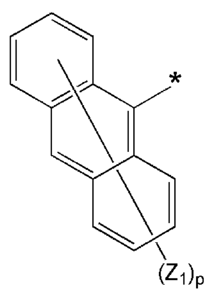

Formula 3I

In Formulae 3A to 3I, $Z_1$ and $Z_2$ may be each independently a deuterium atom, a halogen atom, a hydroxyl group, a cyano group, a nitro group, a carboxyl group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{60}$ cycloalkyl group, a substituted or unsubstituted $C_3$-$C_{60}$ cycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, or a substituted or unsubstituted $C_2$-$C_{60}$ heteroaryl group; p is an integer from 0 to 9; and q is an integer from 0 to 4.

For example, in Formulae 3A to 3I, $Z_1$ and $Z_2$ may be each independently a deuterium atom, a halogen atom, a hydroxyl group, a cyano group, a nitro group, a carboxyl group, a substituted or unsubstituted $C_1$-$C_{20}$ alkyl group, or a substituted or unsubstituted $C_1$-$C_{20}$ alkoxy group.

For example, $Z_1$ and $Z_2$ of Formulae 3A to 3I may be each independently at least one of a deuterium atom; F; Cl; a hydroxyl group; a cyano group; a nitro group; a carboxyl group; a methyl group; an ethyl group; a propyl group; an i-propyl group; a butyl group; an i-butyl group; a t-butyl group; a pentyl group; a hexyl group; a heptyl group; an octyl group; a 2-ethylhexyl group; a nonyl group; a decyl group; a 3,7-dimethyloctyl group; a methyl group, an ethyl group, a propyl group, an i-propyl group, a butyl group, an i-butyl group, a t-butyl group, a pentyl group, a hexyl group, a heptyl group, an octyl group, a 2-ethylhexyl group, a nonyl group, a decyl group, and 3,7-dimethyloctyl that are each substituted with at least one of a deuterium atom, F, Cl, a hydroxyl group, a cyano group, a nitro group, and a carboxyl group; a methoxy group; an ethoxy group; a propyloxy group; an i-propyloxy group; a butoxy group; an i-butoxy group; a t-butoxy group; a pentyloxy group; a hexyloxy group; a heptyloxy group; an octyloxy group; a 2-ethylhexyloxy group; a nonyloxy group; a decyloxy group; a 3,7-dimethyloctyloxy group; and a methoxy group, an ethoxy group, a propyloxy group, an i-propyloxy group, a butoxy group, a i-butoxy group, a t-butoxy group, a pentyloxy group, a hexyloxy group, a heptyloxy group, an octyloxy group, a 2-ethylhexyloxy group, a nonyloxy group, a decyloxy group, and a 3,7-dimethyloctyloxy group that are each substituted with at least one of a deuterium atom, F, Cl, a hydroxyl group, a cyano group, a nitro group, and a carboxyl group.

In Formulae 3A to 3I, p may be an integer from 0 to 3, and in some embodiments, may be an integer from 1 to 3; and q may be an integer from 0 to 2, and in some embodiments, may be an integer of 1 or 2, but p and q are not limited thereto.

For example, in Formula 1, $R_2$ to $R_7$ may be hydrogen atoms, and $R_1$ may be represented by Formula 4A below, but $R_2$ to $R_7$ and $R_1$ are not limited thereto:

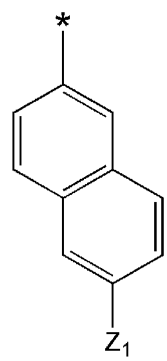

Formula 4A

$Z_1$ in Formula 4A is defined above, so a detailed description thereof will not be recited here.

The first aromatic ring and the second aromatic ring of the polymer may be substituted or unsubstituted benzene rings. For example, the first aromatic ring and the second aromatic ring may be pure substituted or unsubstituted benzene rings. In an embodiment, the first aromatic ring and the second aromatic ring may be benzene rings fused in substituted or unsubstituted naphthalene rings or in substituted or unsubstituted fluorene rings.

The polymer further includes a second repeating unit represented by Formula 5A, 5B, 5C, 5D or 5E:

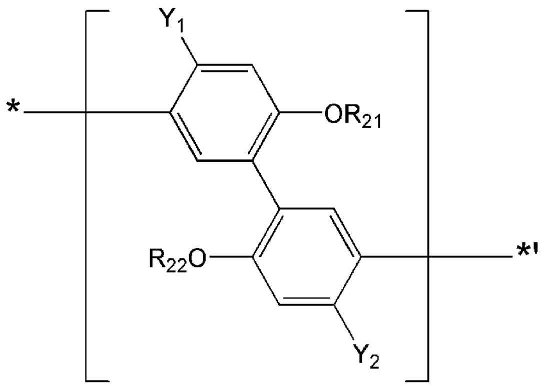

Formula 5A

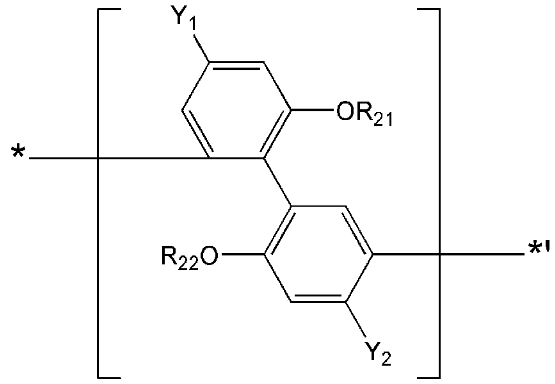

Formula 5B

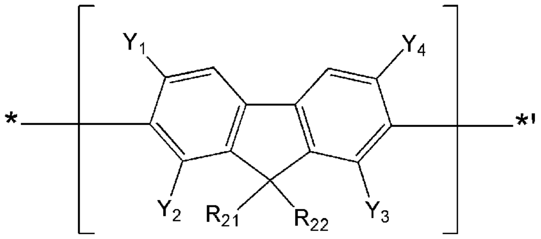

Formula 5C

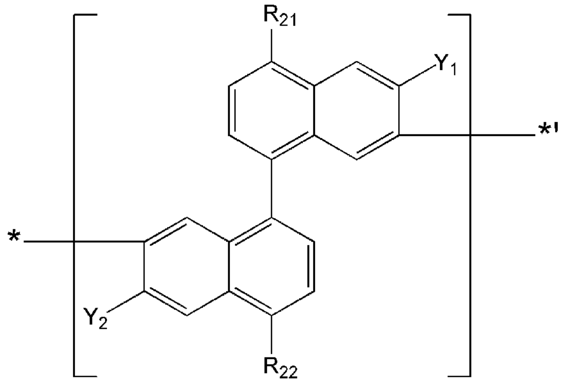

Formula 5D

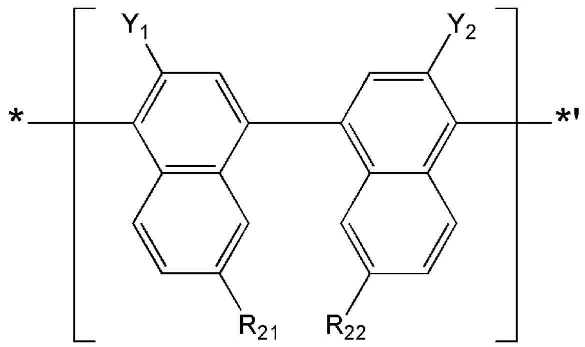

Formula 5E

In Formulae 5A to 5E, $R_{21}$ and $R_{22}$ may be each independently a substituted or unsubstituted $C_1$-$C_{60}$ alkyl group (for example, a substituted or unsubstituted $C_1$-$C_{20}$ alkyl group); $Y_1$ to $Y_4$ may be each independently a hydrogen atom, a substituted or unsubstituted $C_1$-$C_{60}$ alkyl group (for example, a substituted or unsubstituted $C_1$-$C_{20}$ alkyl group), or a substituted or unsubstituted $C_1$-$C_{60}$ alkoxy group (for example, a substituted or unsubstituted $C_1$-$C_{20}$ alkoxy group).

For example, $R_{21}$ and $R_{22}$ may be each independently a methyl group; an ethyl group; a propyl group; an i-propyl group; a butyl group; an i-butyl group; a t-butyl group; a pentyl group; a hexyl group; a heptyl group; an octyl group; a 2-ethylhexyl group; a nonyl group; a decyl group; a 3,7-dimethyloctyl group; and a methyl group, an ethyl group, a propyl group, an i-propyl group, a butyl group, an i-butyl group, a t-butyl group, a pentyl group, a hexyl group, a heptyl group, an octyl group, a 2-ethylhexyl group, a nonyl group, a decyl group, and a 3,7-dimethyloctyl that are each substituted with at least one of a deuterium atom, F, Cl, a hydroxyl group, a cyano group, a nitro group, and a carboxyl group, but are not limited thereto.

For example, $Y_1$ to $Y_4$ may be each independently a hydrogen atom; a methyl group; an ethyl group; a propyl

group; an i-propyl group; a butyl group; an i-butyl group; a t-butyl group; a pentyl group; a hexyl group; a heptyl group; an octyl group; a 2-ethylhexyl group; a nonyl group; a decyl group; a 3,7-dimethyloctyl group; a methyl group, an ethyl group, a propyl group, an i-propyl group, a butyl group, an i-butyl group, a t-butyl group, a pentyl group, a hexyl group, a heptyl group, an octyl group, a 2-ethylhexyl group, a nonyl group, a decyl group, and a 3,7-dimethyloctyl group that are each substituted with at least one of a deuterium atom, F, Cl, a hydroxyl group, a cyano group, a nitro group, and a carboxyl group; a methoxy group; an ethoxy group; a propyloxy group; an i-propyloxy group; a butoxy group; an i-butoxy group; a t-butoxy group; a pentyloxy group; a hexyloxy group; a heptyloxy group; an octyloxy group; a 2-ethylhexyloxy group; a nonyloxy group; a decyloxy group; a 3,7-dimethyloctyloxy group; a methoxy group, an ethoxy group, a propyloxy group, an i-propyloxy group, a butoxy group, an i-butoxy group, a t-butoxy group, a pentyloxy group, a hexyloxy group, a heptyloxy group, an octyloxy group, a 2-ethylhexyloxy group, a nonyloxy group, a decyloxy group, and a 3,7-dimethyloctyloxy group that are each substituted with at least one of a deuterium atom, F, Cl, a hydroxyl group, a cyano group, a nitro group, and a carboxyl group; but are not limited thereto.

The polymer may be a copolymer consisting of the first repeating unit and the second repeating unit. The copolymer may be a block copolymer, a random copolymer, or an alternating copolymer. For example, the copolymer may be an alternating copolymer consisting of the first repeating unit and the second repeating unit.

In some other embodiments, the polymer may be an alternating polymer consisting of a repeating unit represented by Formula 6A or 6B:

Formula 6A

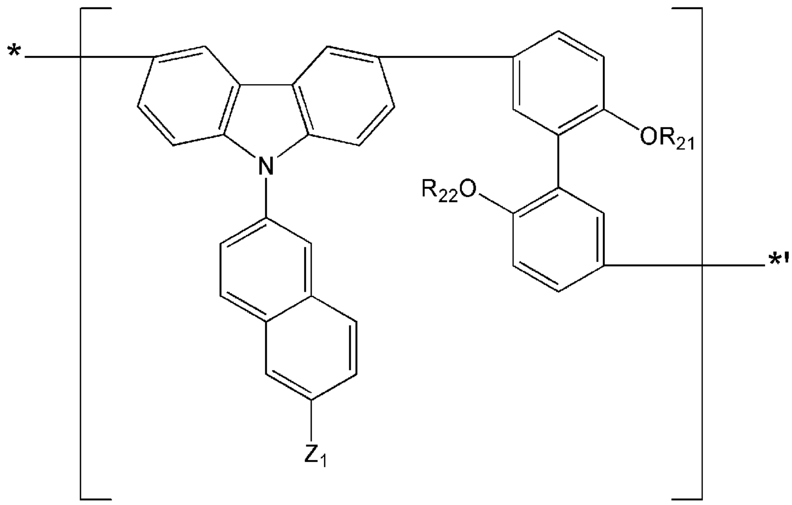

Formula 6B

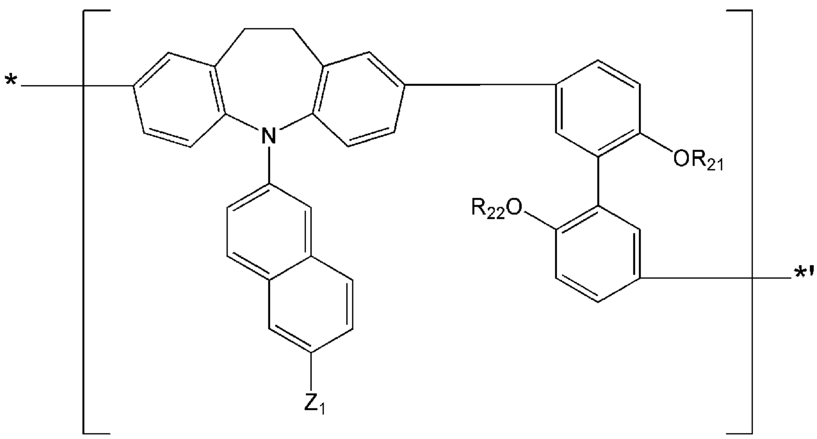

$Z_1$, $R_{21}$, and $R_{22}$ in Formulae 6A and 6B are defined above, so a detailed description thereof will not be recited here.

A weight average molecular weight of the polymer of Formula 1 may be from 2,000 to 1,000,000 on the basis of polystyrene, and a polydispersity index (PDI) thereof may be from 1.5 to 5, but the weight average molecular weight and the PDI of the polymer are not limited thereto. The weight average molecular weight and the PDI, which may be obtained, for example, by gel permeation chromatography (GPC) on the basis of polystyrene calibration, may be determined in consideration of, for example, a structure and desired characteristics of an organic light-emitting device including the polymer.

As used herein, the term "substituted X" in the term "substituted or unsubstituted X (wherein X is a group" refers to a group X of which at least one hydrogen atom is substituted with a deuterium atom, a halogen atom, a hydroxyl group, a nitro group, a cyano group, an amidino group, a hydrazinyl group, a carboxylic acid group or a salt derivative thereof, a sulfonic acid group or a salt derivative thereof, a phosphoric acid group or a salt derivative thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{60}$ cycloalkyl group, a substituted or unsubstituted $C_3$-$C_{60}$ cycloalkenyl group, a substituted or unsubstituted $C_6$-$C_{60}$ aryl group, a substituted or unsubstituted $C_6$-$C_{60}$ aryloxy group, a substituted or unsubstituted $C_2$-$C_{60}$ heteroaryl group,-N($Q_{101}$)($Q_{102}$), or -Si($Q_{103}$)($Q_{104}$)($Q_{105}$), wherein $Q_{101}$ to $Q_{105}$ may be each independently a hydrogen atom, a halogen atom, a hydroxyl group, a cyano group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{60}$ cycloalkyl group, a substituted or unsubstituted $C_3$-$C_{60}$ cycloalkenyl group, a substituted or unsubstituted $C_6$-$C_{60}$ aryl group, a substituted or unsubstituted $C_6$-$C_{60}$ aryloxy group, or a substituted or unsubstituted $C_2$-$C_{60}$ heteroaryl group. If the number of substituents is at least 2, the substituents may be identical to or different from each other.

In some embodiments, the "substituted X" may refer to a group X of which at least one hydrogen atom is substituted with a deuterium atom, a halogen atom, a hydroxyl group, a cyano group, a substituted or unsubstituted $C_1$-$C_{10}$ alkyl group, a substituted or unsubstituted $C_1$-$C_{10}$ alkoxy group, a substituted or unsubstituted $C_6$-$C_{20}$ aryl group, a substituted or unsubstituted $C_2$-$C_{20}$ heteroaryl group, -N($Q_{101}$)($Q_{102}$), or-Si($Q_{103}$)($Q_{104}$)($Q_{105}$), wherein $Q_{101}$ to $Q_{105}$ may be each independently a hydrogen atom, a halogen atom, a hydroxyl group, a cyano group, a substituted or unsubstituted $C_1$-$C_{10}$ alkyl group, a substituted or unsubstituted $C_1$-$C_{10}$ alkoxy group, a substituted or unsubstituted $C_6$-$C_{20}$ aryl group, or a substituted or unsubstituted $C_2$-$C_{20}$ heteroaryl group.

In some embodiments, the "substituted X" may refer to a group X of which at least one hydrogen atom is substituted with a deuterium atom, a halogen atom, a hydroxyl group, a cyano group, a $C_1$-$C_{10}$ alkyl group, a $C_1$-$C_{10}$ alkoxy group, a $C_6$-$C_{20}$ aryl group, a $C_2$-$C_{20}$ heteroaryl group, -N($Q_{101}$)($Q_{102}$), or -Si($Q_{103}$)($Q_{104}$)($Q_{105}$), wherein $Q_{101}$ to $Q_{105}$ may be each independently a hydrogen atom, a halogen atom, a hydroxyl group, a cyano group, a $C_1$-$C_{10}$ alkyl group, a $C_1$-$C_{10}$ alkoxy group, a $C_6$-$C_{20}$ aryl group, or a $C_2$-$C_{20}$ heteroaryl group.

In some embodiments, the "substituted X" may refer to a group X of which at least one hydrogen atom is substituted with a deuterium atom, a halogen atom, a hydroxyl group, a cyano group, a methyl group, an ethyl group, a propyl group, a butyl group, a pentyl group, a methoxy group, an ethoxy group, a propoxy group, a pentoxy group, a phenyl group, a naphthyl group, or an anthryl group.

As used herein, the term "unsubstituted $C_1$-$C_{60}$ alkyl group" may have a linear or branched group. Examples of the $C_1$-$C_{60}$ alkyl group include, but are not limited to, methyl, ethyl, propyl, isobutyl, sec-butyl, pentyl, iso-amyl, hexyl, heptyl, octyl, nonyl, and the like. Substituents of the substituted $C_1$-$C_{60}$ alkyl group are the same as described above in conjunction with the "substituted X".

As used herein, the unsubstituted $C_2$-$C_{60}$ alkenyl group indicates a hydrocarbon chain having at least one carbon-carbon double bond in the center or at a terminal of the unsubstituted $C_2$-$C_{60}$ alkyl group. Nonlimiting examples of the unsubstituted $C_2$-$C_{60}$ alkenyl group include ethenyl, propenyl, butenyl, pentenyl, hexenyl, heptenyl, octenyl, propadienyl, isoprenyl, and allyl. Substituents of the substituted $C_2$-$C_{60}$ alkenyl group are the same as described above in conjunction with the "substituted X".

As used herein, the unsubstituted $C_2$-$C_{60}$ alkenyl group indicates a hydrocarbon chain having at least one carbon-carbon triple bond in the center or at a terminal of the unsubstituted $C_2$-$C_{60}$ alkyl group. An example of the unsubstituted $C_2$-$C_{60}$ alkynyl group is acetylenyl. Substituents of the substituted $C_2$-$C_{60}$ alkynyl group are the same as described above in conjunction with the "substituted X".

As used herein, the unsubstituted $C_1$-$C_{60}$ alkoxy group refers to a group having a structure of -OY, wherein Y is an unsubstituted $C_1$-$C_{60}$ alkyl group as described above. Examples of the unsubstituted $C_1$-$C_{60}$ alkoxy group include a methoxy group, an ethoxy group, an isopropyloxy group, a butoxy group, and a pentoxy group. Substituents of the substituted $C_1$-$C_{60}$ alkoxy group are the same as described above in conjunction with the "substituted X".

As used herein, the unsubstituted $C_3$-$C_{60}$ cycloalkyl group indicates a cyclic saturated hydrocarbon group. Nonlimiting examples of the unsubstituted $C_3$-$C_{60}$ cycloalkyl group include cyclopropyl, cyclobutyl, cyclopentyl, cyclohexyl, and cyclooctyl. Substituents of the substituted $C_3$-$C_{60}$ cycloalkyl group are the same as described above in conjunction with the "substituted X".

As used herein, the unsubstituted $C_3$-$C_{60}$ cycloalkenyl group indicates a nonaromatic, cyclic unsaturated hydrocarbon group with at least one carbon-carbon double bond. Examples of the unsubstituted $C_3$-$C_{60}$ cycloalkenyl group include cyclopropenyl, cyclobutenyl, cyclopentenyl, cyclohexcenyl, cycloheptenyl, 1,3-cyclohexadienyl, 1,4-cyclohexadienyl, 2,4-cycloheptadienyl, and 1,5-cyclooctadienyl. Substituents of the substituted $C_3$-$C_{60}$ cycloalkenyl group are the same as described above in conjunction with the "substituted X".

As used herein, the unsubstituted $C_6$-$C_{60}$ aryl group indicates a monovalent group including a $C_6$-$C_{60}$ carbocyclic aromatic system, which may be monocyclic or polycyclic. In a polycyclic group, at least two rings may be fused to each other. Examples of the unsubstituted $C_6$-$C_{60}$ aryl group include phenyl, pentalenyl, indenyl, naphtyl, azulenyl, heptalenyl, indacenyl, acenaphtyl, fluorenyl, spiro-fluorenyl, phenalenyl, phenanthryl, anthryl, fluoranthenyl, triphenylenyl, pyrenyl, chrysenyl, naphthacenyl, picenyl, perylenyl, pentaphenyl, and hexacenyl. Substituents of the substituted $C_6$-$C_{60}$ aryl group are the same as described above in conjunction with the "substituted X".

As used herein, the unsubstituted $C_2$-$C_{60}$ heteroaryl group indicates a monocyclic or polycyclic group including at least one ring with at least one heteroatom selected from among N, O, P, and S. In a polycyclic group, at least two rings may be fused to each other. Examples of the unsubstituted $C_2$-$C_{60}$ heterocyclic group include pyrrolyl, imidazolyl, pyrazolyl, pyridinyl, pyrazinyl, pyrimidinyl, pyridazinyl, isoindolyl, indolyl, indazolyl, purinyl, quinolinyl, benzoquinolinyl, phthalazinyl, naphthyridinyl, quinoxalinyl, quinazolinyl, cinnolinyl, carbazolyl, phenanthridinyl, acridinyl, phenanthrolinyl, phenazinyl, benzooxazolyl, benzoimidazolyl, furanyl, benzofuranyl, thiophenyl, benzothiophenyl, thiazolyl, isothiazolyl, benzothiazolyl, isoxazolyl, oxazolyl, triazolyl , tetrazolyl, oxadiazolyl, triazinyl, and benzooxazolyl. Substituents of the substituted $C_6$-$C_{60}$ heteroaryl group are the same as described above in conjunction with the "substituted X".

As used herein, "*" and "*'" indicate binding sites with neighboring moieties, which would be understood by one of ordinary skill in the art.

The polymer including the first repeating unit of Formula 1 may be synthesized using a known organic synthesis method, for example, using Suzuki coupling or Yamamoto coupling. A synthesis method of the polymer may be understood by those of ordinary skill in the art from the examples that are described below.

Thus, the polymer may be used in an organic light-emitting device, for example, as a phosphorescent host in an emission layer of an organic light-emitting device along with a phosphorescent dopant.

Compared to fluorescence materials with a mere 25% internal quantum efficiency at maximum due to the involvement of only a singlet state energy level in light emission, phosphorescent materials that allow intersystem crossing between singlet and triplet state energy levels may theoretically have a 100% internal quantum efficiency due to the excitons of triplet state energy level involved in light emission. Therefore, a high-efficiency organic light-emission device may be implemented using a phosphorescent material. In consideration that known phosphorescent dopants have high triplet state energy and the above-described characteristics of the polymer, the polymer may be used as a phosphorescent host in an emission layer of an organic light-emitting device.

In some embodiments, the polymer may be used as a red, green, and/or blue phosphorescent host in an emission layer of an organic light-emitting device. In some other embodiments, the polymer may be used as a red and/or green phosphorescent host in an emission layer of an organic light-emitting device, but is not limited thereto.

According to another exemplary embodiment of the present disclosure, an organic light-emitting device (OLED) includes a substrate, a first electrode, a second electrode, and a first layer disposed between the first electrode and the second electrode, the first layer including the above-described polymer.

The first layer may function as, for example, an emission layer.

If the first layer is an emission layer, the first layer may further include a phosphorescent dopant. The phosphorescent dopant used in the first layer may be any known phosphorescent dopant. For example, the phosphorescent dopant may include an organometallic complex including at least one of iridium (Ir), platinum (Pt), osmium (Os), rhenium (Re), titanium (Ti), zirconium (Zr), hafnium (Hf), or a combination of at least two thereof.

For example, the phosphorescent dopant may include at least one of bisthienylpyridine acetylacetonate iridium, bis(benzothienylpyridine)acetylacetonate iridium, bis(2-phenylbenzothiazole)acetylacetonate iridium, bis(1-phenylisoquinoline) iridium acetylacetonate, tris(1-phenylisoquinoline) iridium, tris(phenylpyridine) iridium, tris(2-biphenylpyridine) iridium, tris(3-biphenyl pyridine) iridium, tris(4-biphenyl pyridine) iridium, $Ir(pq)_2(acac)$ (wherein "pq" is an abbreviation for 2-phenylquinoline; and "acac" is an abbreviation for acetylacetone, see Compound 10 below), $Ir(ppy)_3$ (wherein "ppy" is an abbreviation for phenylpyridine, see Compound 11 below), platinum(II)octaethylporphyrin (PtOEP, see a compound below), Compound 12 below, Firpic (see Compound 13 below), $Ir(piq)_3$ (see a compound below), $Ir(piq)_2acac$ (wherein "piq" is an abbreviation for phenylisoquinoline, see Compound 14 below), $Ir(mppy)_3$ (see Dopant 1 below), Dopant 2 below, $Btp_2Ir(acac)$ (see a compound below), $F_2Irpic$ (see a compound below), $(F_2ppy)_2Ir(tmd)$ (see a compound below), and $Ir(dfppz)_3$ (see a compound below), but is not limited thereto:

Compound 10

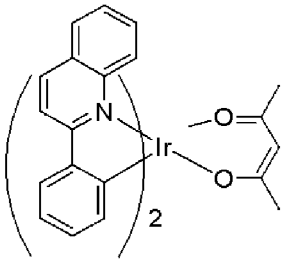

$Pq_2Ir(acac)$

Compound 11

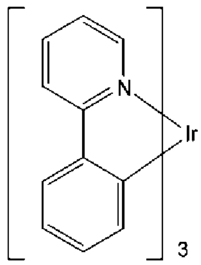

Compound 12

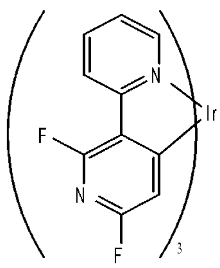

Compound 13

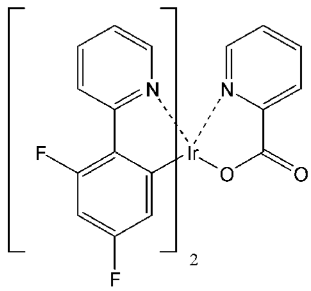

Compound 14

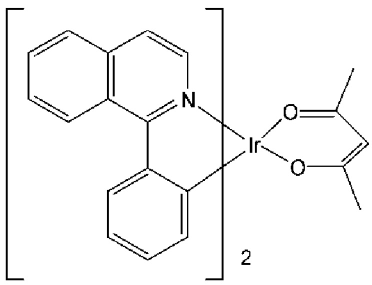

<Dopant 1>

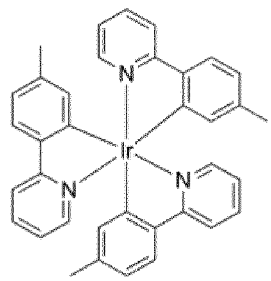

<Dopant 2>

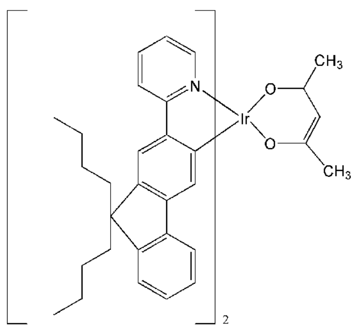

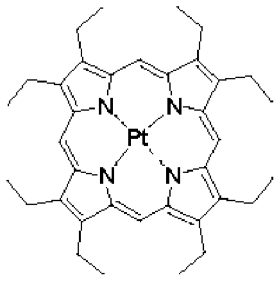

PtOEP

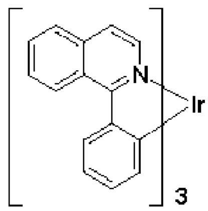

$Ir(piq)_3$

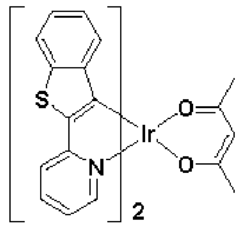

$Btp_2Ir(acac)$

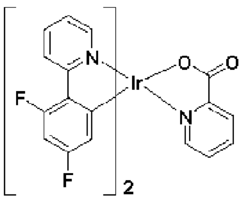

$F_2Irpic$

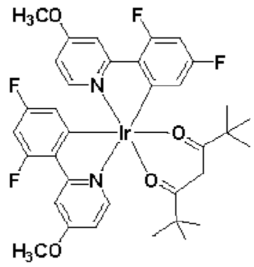

$(F_2ppy)_2Ir(tmd)$

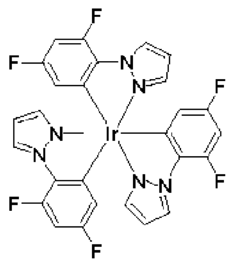

$Ir(dfppz)_3$

In addition to the first layer that may function as an emission layer, as described above, the OLED may further include at least one of a hole injection layer (HIL), a hole transport layer (HTL), a hole blocking layer (HBL), an electron transport layer (ETL), and an electron injection layer (EIL) between the first electrode and the second electrode.

FIG. 1 is a schematic sectional view of an OLED 10 according to an embodiment of the present disclosure. Referring to FIG. 1, the OLED 10 includes a substrate 11, a first electrode 12, an HTL 13, a first layer 15, an ETL 16, an EIL 18, and a second electrode 19. The first layer 15 may function as an emission layer (EML). Hereinafter, the OLED 10 and a method of manufacturing the same will be described in detail.

First, the first electrode 12 is formed on the substrate 11 by deposition, ion plating, plating, or sputtering. The first electrode 12 may be formed of a first electrode-forming material having a high work function. The first electrode 12 may constitute an anode that may inject holes or a cathode that may inject electrons. The substrate 11, which may be any substrate that is used in general OLEDs, may be a glass substrate or a transparent plastic substrate with excellent mechanical strength, thermal stability, transparency, surface smoothness, ease of handling, and water resistance. Examples of the first electrode-forming material include a metal oxide, a metal sulfide, or a metal, all of which have a high electrical conductivity. In general, these materials are used to form a thin film. Examples of the first electrode-forming material include indium oxide, zinc oxide, tin oxide, a combination thereof, such as indium tin oxide (ITO) or indium zinc oxide (IZO), gold (Au), platinum (Pt), silver (Ag), and copper (Cu). Furthermore, polyaniline or a derivative thereof, or polythiophene or a derivative thereof may also be used as the first electrode-forming material. The first electrode 12 may have a monolayered structure or a multilayered structure including at least two layers. The first electrode 12 may contain at least two different materials. The thickness of the first electrode 12 may appropriately vary in consideration of light transmittance and electrical conductivity, for example, may be in the range of 10 nm to 10 $\mu$m.

Next, although not illustrated in FIG. 1, if the first electrode 12 is an anode, HIL may be further formed on the first electrode 12. The HIL may be formed by vacuum deposition, spin coating, casting, inkjet printing, LB deposition, or the like.

When the HIL is formed using vacuum deposition, the deposition conditions may vary according to a material that is used to form the HIL, and the structure and thermal properties of the HIL to be formed. For example, conditions for vacuum deposition may include a deposition temperature of 100 to 500°C, a pressure of $1.33*10^{-9}$ to $1.33*10^{-4}$ kPa ($10^{-8}$ to $10^{-3}$ torr), and a deposition rate of 0.001 to 10 nm/sec.

When the HIL is formed using spin coating, the coating conditions may vary according to a material that is used to form the HIL, and the structure and thermal properties of the HIL to be formed. In general, however, conditions for spin coating may include a coating rate of 2000 to 5000 rpm and a heat treatment temperature of 80 to 300°C for removing a solvent after coating.

The HIL may be formed of any material that is commonly used to form an HIL. Examples of the material that may be used to form the HIL include a phthalocyanine compound such as copper phthalocyanine, 4,4',4"-tris (3-methylphenylphenylamino) triphenylamine (m-MTDATA), N,N'-di(1-naphthyl)-N,N'-diphenylbenzidine (NPB), TDATA (see the formula below), and 2T-NATA (see the formula below), but are not limited thereto.

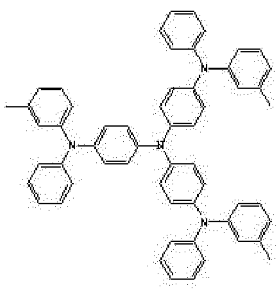

m-MTDATA

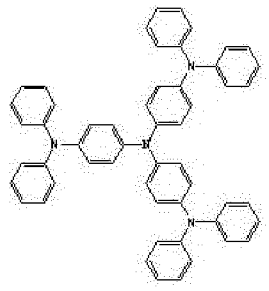

TDATA

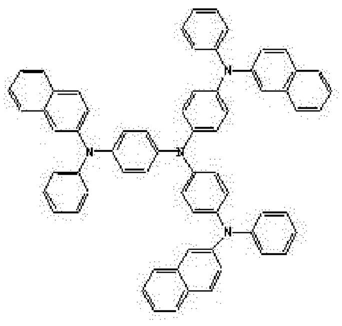

2T-NATA

The thickness of the HIL may be from 10 nm to 1000 nm, and in some other embodiments, may be from 10 nm to 100 nm. When the thickness of the HIL is within these ranges, the HIL may have satisfactory hole injection properties without an increase in a driving voltage.

Next, the HTL 13 may be formed on the first electrode 12 or the HIL by using vacuum deposition, spin coating, casting, inkjet printing, or LB deposition.

When the HTL 13 is formed using vacuum deposition or spin coating, the conditions for deposition and coating are similar to those for the formation of the HIL, though the conditions for the deposition and coating may vary according to the material that is used to form the HTL 13.

The HTL 13 may be formed of any known materials used to form an HTL. Examples of the material that may be used to form the HTL 13 include an amine derivative having an aromatic condensed ring, such as N,N'-bis(3-methylphenyl)-N,N'-diphenyl-[1,1-biphenyl]-4,4'-diamine (TPD, see the formula below), polyaniline/dodecylbenzenesulfonic acid (Pani/DBSA, see the formula below); poly(3,4-ethylenedioxythiophene)/poly(4-styrenesulfonate) (PEDOT/PSS, see the formula below); polyaniline/camphor sulfonicacid (Pani/CSA); and polyaniline/poly(4-styrenesulfonate (PANI/PSS), but are not limited thereto.

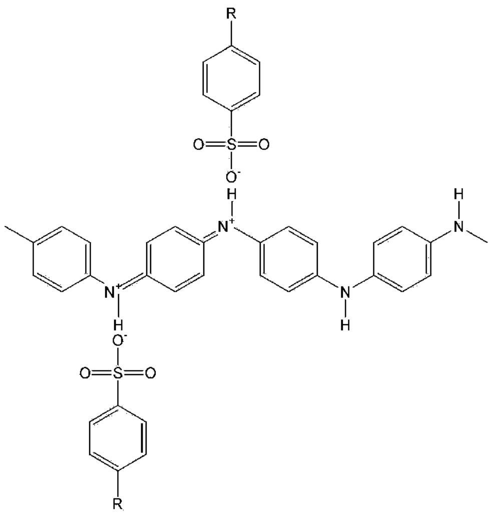

Pani/DBSA

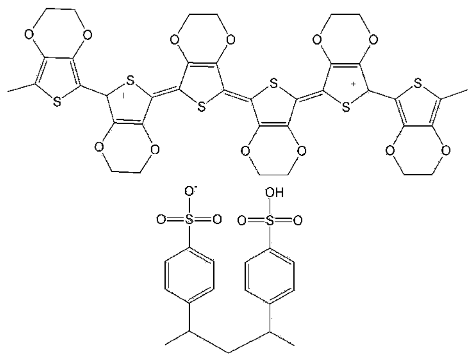

PEDOT/PSS

The thickness of the HTL 13 may be from 5 nm to 100nm, and in some other embodiments, may be from 10 nm to 60 nm. When the thickness of the HTL 13 is within these ranges, the HTL 13 may have satisfactory hole transport properties without a substantial increase in a driving voltage.

The first layer 15, which may function as an emission layer, may be formed on the HTL 13. The first layer 15 may be formed by spin coating, casting, inkjet printing, LB deposition, or the like. When the first layer 15 is formed using spin coating, the conditions for forming the first layer 15 are similar to those for the formation of the HIL 13, though the conditions for forming the first layer 15 may vary according to a polymer and/or a compound that is used to form the first layer 15.

The first layer 15 may include the polymer as a host. In another embodiment, the first layer 15 may further include a phosphorescent dopant, in addition to the above-described polymer. Examples of the phosphorescent dopant

are described above.

If the first layer 15 includes the above-described polymer and a phosphorescent dopant, the amount of the phosphorescent dopant in the first layer 15 may be from 0.5wt% to 10wt% based on a total weight (100 wt%) of the first layer 15. When the amount of the phosphorescent dopant is within this range, concentration quenching may be substantially prevented.

In some other embodiments, the first layer 15 may exclusively include the above-described polymer or may further include a known fluorescent dopant, in addition to the polymer.

The thickness of the first layer 15, which may function as an EML, may be from 10 nm to 100 nm, and in some other embodiments, may be from 20 nm to 90 nm. When the thickness of the first layer 15 is within these ranges, the first layer 15 may have satisfactory light emission characteristics without a substantial increase in a driving voltage.

An HBL may further be formed on the first layer 15, if required, although not illustrated in FIG. 1.

The HBL may prevent triplet excitons or holes in the first layer 15 from diffusing into the second electrode 19. The HBL may be formed by using vacuum deposition, spin coating, casting, LB deposition, or the like. When the HBL is formed using vacuum deposition or spin coating, the deposition and coating conditions may be similar to those for the formation of the HIL, though the conditions for deposition and coating may vary according to the material that is used to form the HBL. Examples of the material that may be used to form the HBL include an oxadiazole derivative, a triazole derivative, a phenanthroline derivative, and TAZ (see the formula below), but are not limited thereto.

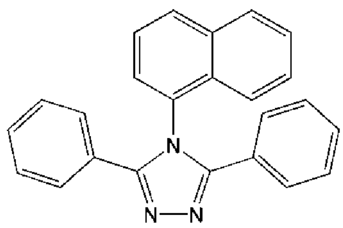

TAZ

The thickness of the HBL may be from 5 nm to 100 nm, and in some other embodiments, may be from 10 nm to 30nm. When the thickness of the HBL is within these ranges, the HBL may have satisfactory hole blocking properties.

Next, the ETL 16 may be formed on the first layer 15 or HBL by using vacuum deposition, spin coating, casting, or the like. When the ETL 16 is formed using vacuum deposition or spin coating, the deposition and coating conditions may be similar to those for the formation of the HIL, though the deposition and coating conditions may vary according to the material that is used to form the ETL. Examples of the material that may be used to form the ETL 16 include any known materials that stably transports electrons injected from an electron injection electrode, that is, a cathode, such as a quinoline derivative, 4,7-diphenyl-1,10-phenanthroline (Bphen), BAlq (see the formula below), tris(8-quinolinorate)aluminum ($Alq_3$), beryllium bis(benzoquinolin-10-olate ($Bebq_2$), or TPBi (see the formula below).

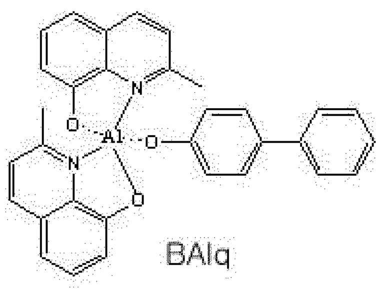

BAlq

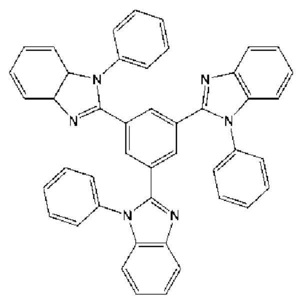

TPBi

The thickness of the ETL 16 may be from 10 nm to 100 nm, and in some other embodiments, may be from 20 nm to 50 nm. When the thickness of the ETL 16 is within these ranges, the ETL 16 may have satisfactory electron transport properties without a substantial increase in a driving voltage.

Next, the EIL 18 may be formed on the ETL 16 or the first layer 15. The EIL 18 may be formed of any known material, such as LiF, NaCl, CsF, $Li_2O$, BaO, $BaF_2$, or the like. The deposition and coating conditions for forming the EIL 18 may be similar to those for the formation of the HIL, though the deposition and coating conditions may vary according to the material that is used to form the EIL 18.

The thickness of the EIL 18 may be from 0.1 nm to 10 nm, and in some other embodiments, may be from 0.5 nm to 5 nm. When the thickness of the EIL 18 is within these ranges, the EIL 18 may have satisfactory electron injection properties without a substantial increase in a driving voltage.

Finally, the second electrode 19 may be formed on the EIL 19. The second electrode 19 may be formed according to the method described above in conjunction with the first electrode 12. The second electrode 19 may constitute a cathode or an anode. When the second electrode 19 constitutes a cathode, the second electrode 19 may be formed of a material having a low work function. Examples of the material having a low work function include an alkali metal, such as lithium (Li), sodium (Na), potassium (K), rubidium (Rb), or cesium (Cs); an alkali earth metal, such as beryllium (Be), magnesium (Mg), calcium (Ca), strontium (Sr), or barium (Ba); a metal, such as aluminum (Al), scandium (Sc), vanadium (V), zinc (Zn), yttrium (Y), indium (In), cerium (Ce), samarium (Sm), europium (Eu), terbium (Tb), or ytterbium (Yb); an alloy of at least two of these metals; an alloy of at least one of these metals with gold (Au), silver (Ag), platinum (Pt), copper (Cu), manganese (Mg), titanium (Ti), cobalt (Co), nickel (Ni), tungsten (W), and tin (Sn); graphite; and a graphite intercalation compound, but are not limited thereto. Examples of alloys that may be used to form the second electrode 19 include a Mg-Ag alloy, a Mg-In alloy, a Mg-Al alloy, an In-Ag alloy, a Li-Al alloy, a Li-Mg alloy, a Li-In alloy, and a Ca-Al alloy. The second electrode 19 may be formed as a monolayer or a multilayer structure including at least two layers. The second electrode 19 may exclusively contain one material or may include two different materials. The second electrode 19 may be implemented in various forms, for example, as a transparent, semitransparent, or reflective electrode. The thickness of the second electrode 19 may be from 10 nm to 10 μm, but is not limited thereto.

One or more embodiments of the present invention will now be described in detail with reference to the following examples. However, these examples are not intended to limit the scope of the one or more embodiments of the present invention.

Examples

**Synthesis Example 1: Synthesis of Polymer A**

<Polymer A: Polymer consisting of the following repeating unit>

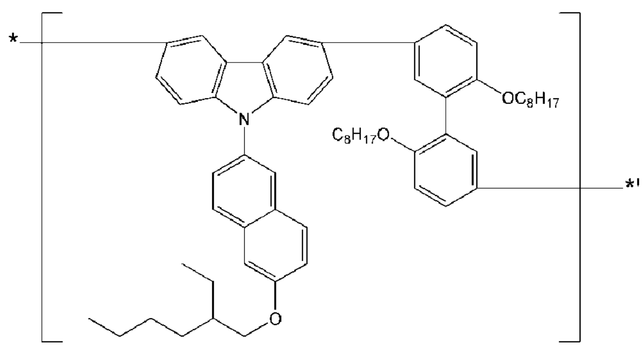

After equipment of a 50 mL, well-dried 2-necked flask with a reflux condenser, 668 mg (1.0 mmol) of Compound B below, 568 mg (1.0 mmol) of Compound C below, 4.49 mg (0.02 mmol) of acetic acid palladium ($Pd(OAC)_2$), and 22.4 mg (0.08 mmol) of tricyclohexylphosphine ($PCy_3$) were put into the flask, which was then connected to a Schlenk line, followed by evacuation several times, and refluxing under a nitrogen atmosphere. Subsequently, after addition of 6 mL of anhydrous toluene in a nitrogen atmosphere by stirring, 45.7 μL (0.1 mmol) of Aliquat 336 and 4 mL of a 2M aqueous potassium carbonate solution were added thereto. The reaction mixture was stirred under reflux conditions and a nitrogen atmosphere for about 48 hours. After addition of 340 mg (2.5 mmol) of *p*-tolyl boronic acid and stirring for 1 hour, 308 μL (2.5 mmol) of 4-bromotoluene was added and further stirred for 2 hours. After completion of the reaction, the temperature of the reaction mixture was decreased to room temperature, diluted by addition of 30 mL of toluene and 30 mL of water, and the organic phase was separated and concentrated. A resulting concentrated compound was dissolved in 10 mL of toluene, and precipitated with 300 mL of methanol, thereby obtaining 680 mL of polymer A. As a result of analyzing the polymer A using gel permeation chromatography (GPC), the polymer A was found to have a weight average molecular weight ($M_w$) of about 1.82 x $10^4$, a number average molecular weight ($M_n$) of about 6.59 x $10^3$, and a molecular weight distribution (MWD) of about 2.76.

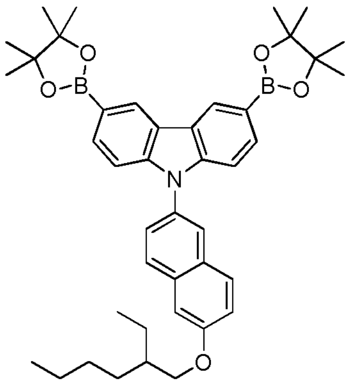

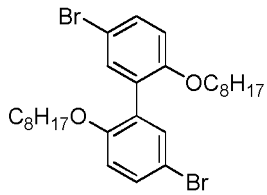

**B** **C**

**Synthesis Example 2: Synthesis of Polymer D**

<Polymer D: Polymer consisting of the following repeating unit>

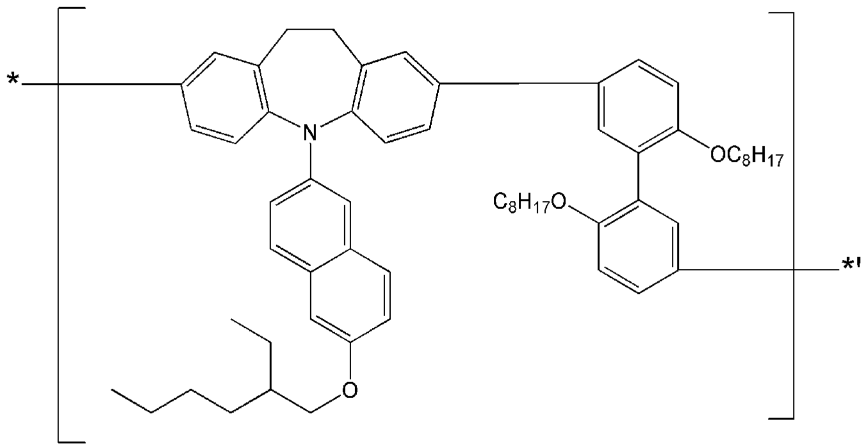

Polymer D was synthesized in the same manner as in Synthesis Example 1, except that Compound E below, instead of Compound B, was used. As a result of analyzing the polymer D using GPC, the polymer D was found to have an $M_w$ of about 7.34 x $10^3$, an $M_n$ of about 3.50 x $10^3$, and an MWD of about 2.10.

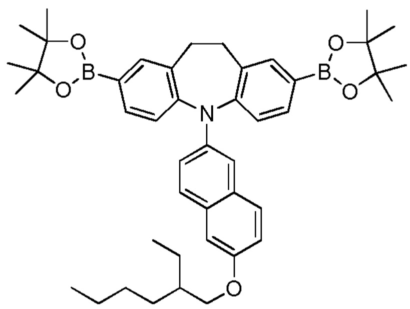

**E**

**Synthesis Example 3: Synthesis of Polymer F (Comparative Synthesis Example)**

<Polymer F: Polymer consisting of the following repeating unit>

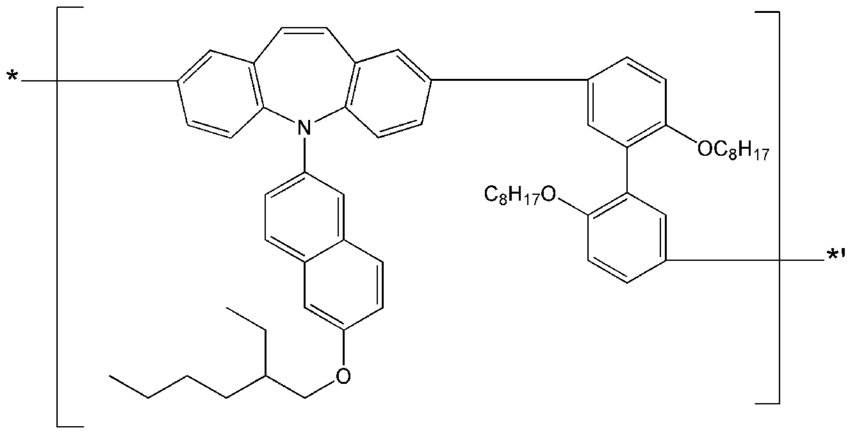

Polymer F was synthesized in the same manner as in Synthesis Example 1, except that Compound G below, instead of Compound B, was used. As a result of analyzing the polymer F using GPC, the polymer F was found to have an $M_w$ of about 6.60 x $10^3$, an $M_n$ of about 3.46 x $10^3$, and an MWD of about 1.91.

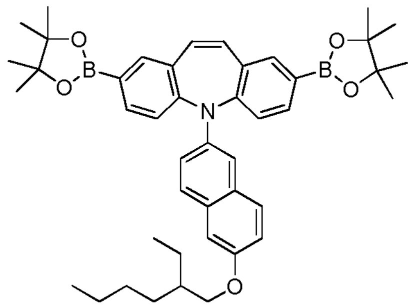

**G**

**Synthesis Example 4: Synthesis of Polymer H**

<Polymer H: Polymer consisting of the following repeating unit>

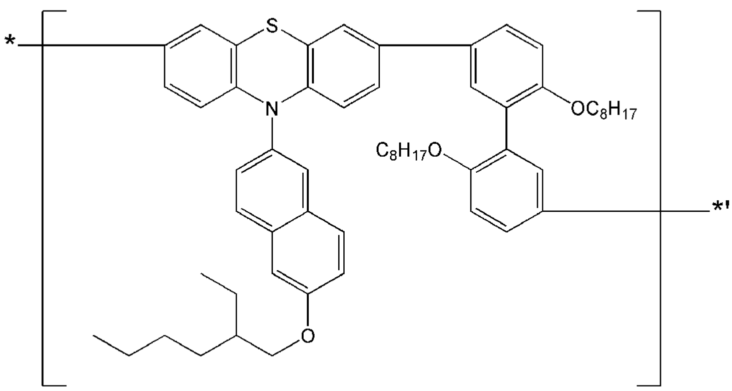

Polymer H was synthesized in the same manner as in Synthesis Example 1, except that Compound I below,

instead of Compound B, was used. As a result of analyzing the polymer H using GPC, the polymer H was found to have an $M_w$ of about $8.05 \times 10^3$, an $M_n$ of about $4.33 \times 10^3$, and an MWD of about 1.86.

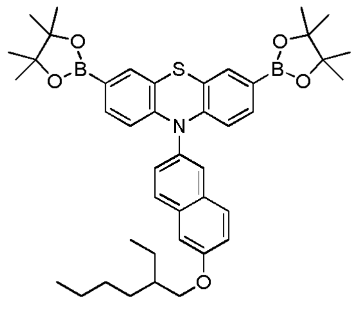

I

**Synthesis Example 5: Synthesis of Polymer J**

<Polymer J: Polymer consisting of the following repeating unit>

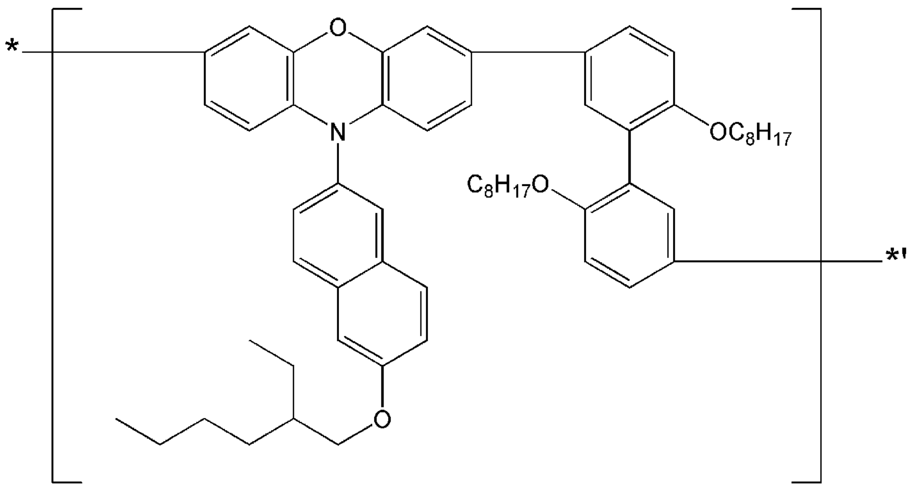

Polymer J was synthesized in the same manner as in Synthesis Example 1, except that Compound K below, instead of Compound B, was used. As a result of analyzing the polymer J using GPC, the polymer J was found to have an $M_w$ of about $2.34 \times 10^4$, an $M_n$ of about $1.09 \times 10^4$, and an MWD of about 2.15.

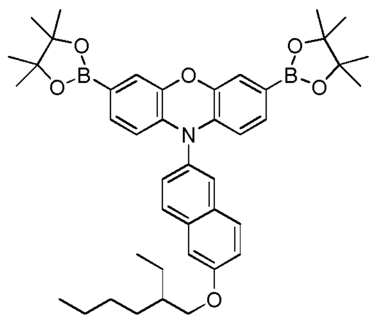

K

**Synthesis Example 5: Synthesis of Polymer L**

<Polymer L: Polymer consisting of the following repeating unit>

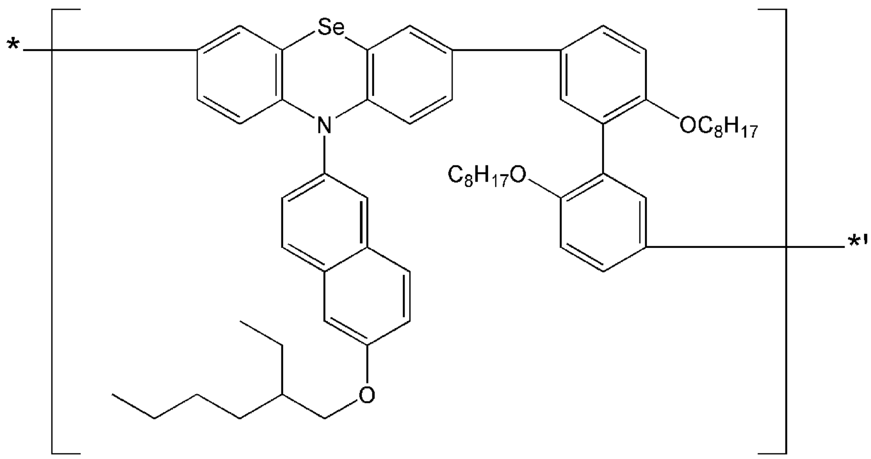

Polymer L was synthesized in the same manner as in Synthesis Example 1, except that Compound M below, instead of Compound B, was used. As a result of analyzing the polymer L using GPC, the polymer L was found to have an $M_w$ of about 8.66 x $10^3$, an $M_n$ of about 4.37 x $10^3$, and an MWD of about 1.98.

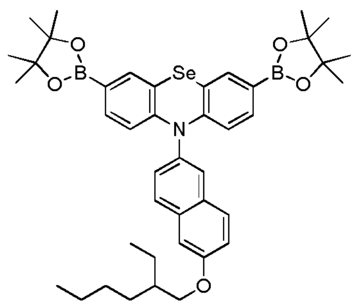

**M**

**Evaluation Example 1: Estimation of $\chi_{50\%}$, dihedral angle, and triplet state energy ($E_{T1}$) of polymers**

Four consecutive repeating units in the main chain of the polymers A, D, and F are represented by Formulas A, D, and F:

Formula A

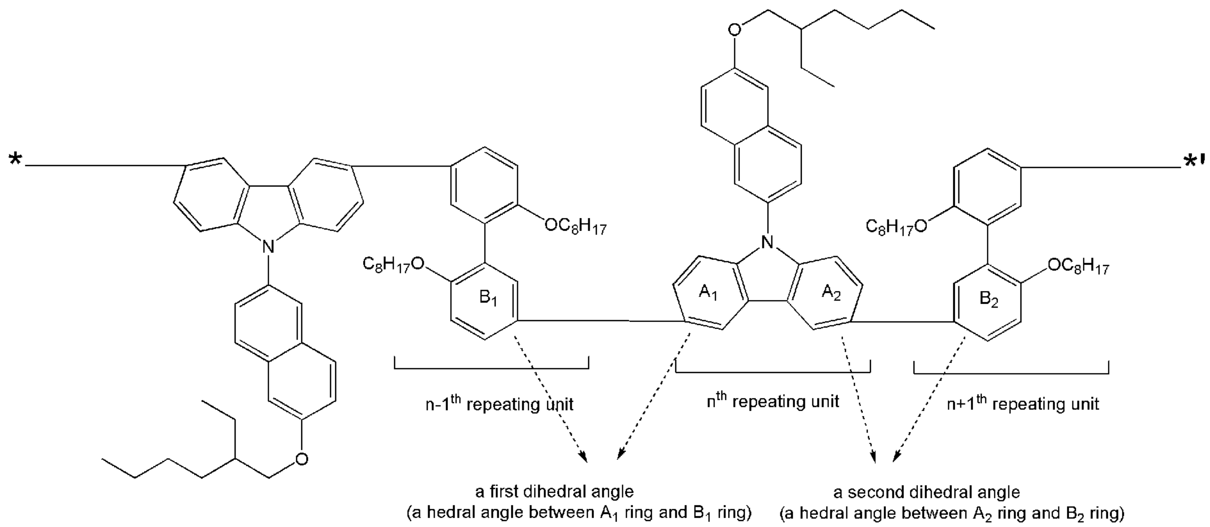


Formula D

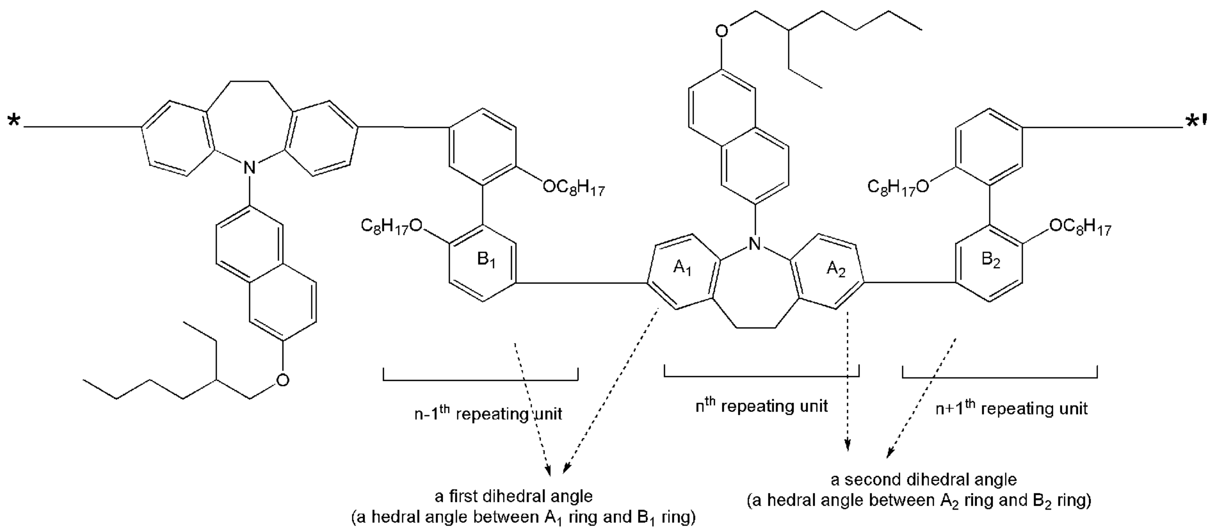


Formula F

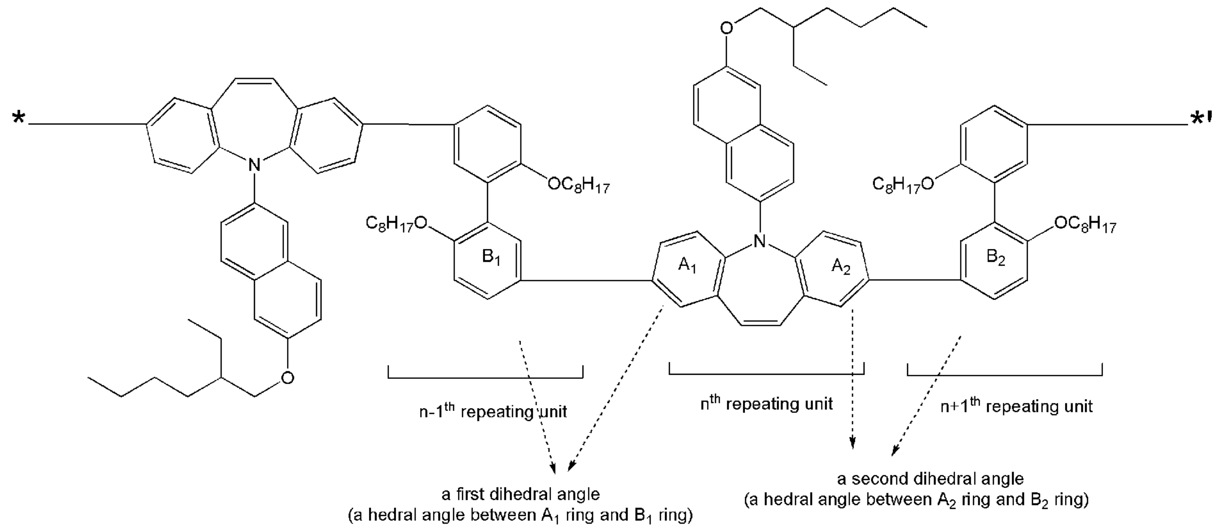


With regard to the polymers A, D, and F, respectively, having units represented by Formulae A, D, and F, $\varphi$ and $\theta$ in the n$^{th}$ repeating unit, a first dihedral angle, a second dihedral angle, and triplet state energy ($E_{T1}$) are estimated using methods described in Table 1 below. The results are shown in Table 2. $\chi_{50\%}$ in Table 2 was calculated according to Equation 1 above:

Table 2

| Parameter | Estimation method |
|---|---|
| $\varphi$ and $\theta$ | Using DFT with (B3LYP/6-31+G(d)), i.e, with the xc-functional of B3LYP and a 6-31+G(D) basis set. |
| First dihedral angle & Second dihedral angle | Using DFT with (B3LYP/6-31+G(d)), i.e., with the xc-functional of B3LYP and a 6-31+G (D) basis set. |
| Triplet state energy ($E_{T1}$) | Using TDDFT with (B3LYP/6-31+G(d), i.e., with the xc-functional of B3LYP and a 6-31+G (D) basis set; or by analyzing only low-temperature peaks (relative to room temperature) from PL spectra of a mixture of a target polymer and toluene (1 mg of the polymer dissolved in 3 cc of toluene), wherein the mixture is contained in a quartz cell, placed in liquid nitrogen (77K), and analyzed using a PL analyzer. |

Table 3

| Polymer No. | $\varphi$ (°) | $\theta$ (°) | $\chi_{50\%}$ (°) | First dihedral angle & Second dihedral angle(°) | $E_{T1}$ (eV) |
|---|---|---|---|---|---|
| A | 180.00 | -33.45 | 28.08 | 38.6 | 2.56 |
| D | 159.37 | 33.52 | 39.08 | 39.2 | 2.45 |
| F | 145.48 | 28.28 | 37.50 | 31.3 | 1.81 |

Referring to Table 3, the Polymers A and D were found to have a first dihedral angle and a second dihedral angle that are greater than $\chi_{50\%}$ of Polymers A and D, respectively, and a high triplet state energy relative to the polymer F, whereas the polymer F has a first dihedral angle and a second dihedral angle that are smaller than $\chi_{50\%}$ of Polymer F and a relatively low triplet state energy.

**Evaluation Example 2: Evaluation of light-emitting properties of polymers (in solution)**

Light-emitting properties of the polymer A were evaluated using PL spectra. First, the polymer A was diluted to a concentration of 10 mM with toluene, and the PL of the solution was measured using an ISC PC1 Spectrofluorometer equipped with a Xenon lamp.

FIG. 2 shows that the polymer A in the solution has better light-emitting characteristics.

**Example 1**

First, a transparent electrode substrate formed by coating a glass substrate with indium-tin oxide (ITO) was cleaned. Then, the ITO layer was patterned using a photosensitive resin and an etchant into a desired pattern, followed by further cleaning. An HTL composition (Batron P 4083, available from Bayer AG) containing 3,4-ethylenedioxythiopene (PEDOT) was coated on the ITO layer and baked at about 200°C for about 0.5 hours to form an HTL. An EML composition containing the polymer A and 0.7 wt% of Dopant 1 in chlorobenzene was spin-coated on the HTL and baked at about 120°C for 30 minutes to form an EML containing the polymer A and Dopant 1. The HTL composition and the EML composition were filtered using a 0.2-mm filter prior to the coating. The concentrations and coating rates of the HTL composition and the EML compositions were adjusted to form an HTL and an EML having a thickness of about 55 nm and about 40 nm, respectively. TPBi was vacuum-deposited on the EML at a pressure of $5.32 \times 10^{-7}$ kPa ($4\times10^{-6}$ torr) or less to form an ETL having a thickness of about 30 nm. Then, LiF and Al were sequentially deposited on the ETL to form an EIL having a thickness of about 0.5 nm and a second electrode having a thickness of about 100 nm, thereby manufacturing an OLED. The thickness and growth rate of each of the layers were adjusted using a crystal sensor during the deposition process.

<PEDOT:PSS>

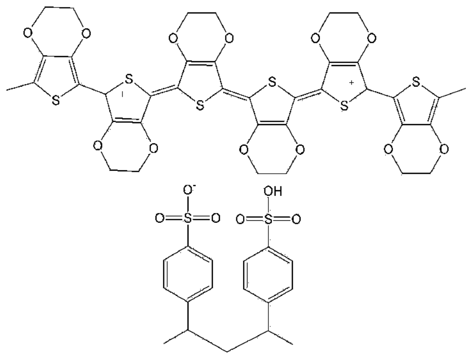

<Dopant 1>

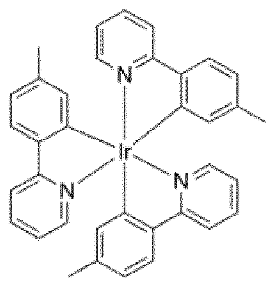

<TPBi>

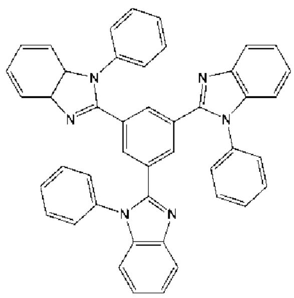

**Example 2**

An OLED was manufactured in the same manner as in Example 1, except that Dopant 2, instead of Dopant 1, was used to form the EML.

<Dopant 2>

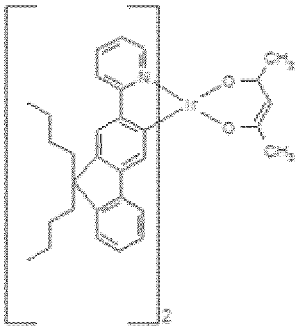

**Example 3**

An OLED was manufactured in the same manner as in Example 1, except that Polymer D, instead of Polymer A, was used to form the EML.

The structures of the OLEDs of Examples 1 to 3 are summarized in Table 1 below:

Table 4

| | Anode | HTL | Emission layer | ETL | EIL/ Cathode |
|---|---|---|---|---|---|
| Example 1 | ITO (150nm) | PEDOT:PSS (55nm) | Polymer A:Dopant 1 (0.7wt%) (40nm) | TPBi (30nm) | LiF(0.5nm)/ Al (100 nm) |
| Example 2 | ITO (150nm) | PEDOT:PSS (55nm) | Polymer A:Dopant 2 (0.7wt%) (40nm) | TPBi (30nm) | LiF (0.5nm)/ Al (100 nm) |
| Example 3 | ITO (150nm) | PEDOT:PSS (55nm) | Polymer D:Dopant 1 (0.7wt%) (40nm) | TPBi (30nm) | LiF(0.5nm)/ Al (100 nm) |

**Evaluation Example 3: Evaluation of characteristics of OLEDs**

Electroluminescence spectrum, current density, current efficiency, and luminance of the OLEDs of Examples 1 to 3 were evaluated using a PR650 Spectroscan Source Measurement Unit (available from PhotoResearch). The results are shown in FIGS. 3 to 12.

Referring to FIGS. 3 to 12, the OLEDs of Examples 1 to 3 including the polymer A or D were found to have better current density and luminance characteristics.

As described above, according to the one or more of the above embodiments of the present invention, a polymer including a repeating unit of Formula 1 above may have a high triplet state energy level, and thus an OLED including the polymer may have high current density and high luminance characteristics.

**Claims**

**1.** A polymer comprising m repeating units, wherein an $n^{th}$ repeating unit of the m repeating units is a first repeating unit represented by Formula 1 below, wherein, when estimated by density functional theory using the B3LYP exchange functional and a 6-31+G(d) basis set, at least one of a first dihedral angle between an $A_1$ ring of the $n^{th}$ repeating unit and a first aromatic ring of an $(n-1)^{th}$ repeating unit and a second dihedral angle between an $A_2$ ring of the $n^{th}$ repeating unit and a second aromatic ring of a $(n+1)^{th}$ repeating unit is equal to or greater than an angle of $\chi_{50\%}$ represented by Equation 1:

Formula 1

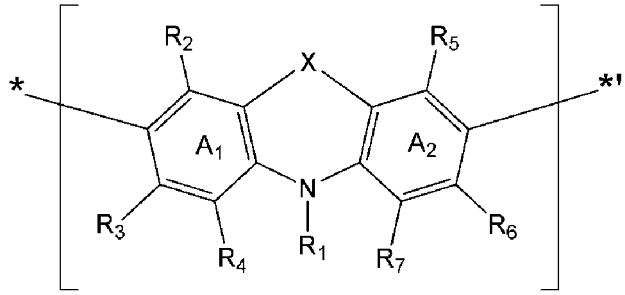

Equation 1

$$\chi_{50\%} = A + B(\varphi + 4\theta)$$

wherein the first aromatic ring is bound to the $A_1$ ring by a single bond;
the second aromatic ring is bound to the $A_2$ ring by a single bond;
$R_1$ to $R_7$ of Formula 1 are each independently one of a hydrogen atom, a deuterium atom, a halogen atom, a hydroxyl group, a cyano group, a nitro group, a carboxyl group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{60}$ cycloalkyl group, a substituted or unsubstituted $C_3$-$C_{60}$ cycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_2$-$C_{60}$ heteroaryl group, -N($Q_1$)($Q_2$), and -Si($Q_3$)($Q_4$)($Q_5$), wherein $Q_1$ to $Q_5$ are each independently a hydrogen atom, a deuterium atom, a halogen atom, a hydroxyl group, a cyano group, a nitro group, a carboxyl group, a $C_1$-$C_{60}$ alkyl group, a $C_2$-$C_{60}$ alkenyl group, a $C_2$-$C_{60}$ alkynyl group, a $C_3$-$C_{60}$ cycloalkyl group, a $C_6$-$C_{60}$ aryl group, or a $C_2$-$C_{60}$ heteroaryl group;
X of Formula 1 is a single bond, or a linker including carbon or a Group 16 element;
m is an integer from 2 to 1000;
n is a variable of from 2 to m-1;
A of Formula 1 is 26.03, and B is 0.0445;

$\varphi$ of Equation 1 is an angle between the $A_1$ ring and $A_2$ ring of Formula 1, as illustrated in Formula 1-1 below; and
$\theta$ of Equation 1 is an angle between a first imaginary line extending from a bond between the $A_1$ ring and a $A_3$ ring of Formula 1 in a direction close to nitrogen of the $A_3$ ring and a second imaginary line extending from a bond between the $A_2$ ring and $A_3$ ring in a direction close to the nitrogen of the $A_3$ ring, as illustrated in Formula 1-2 below:

Formula 1-1

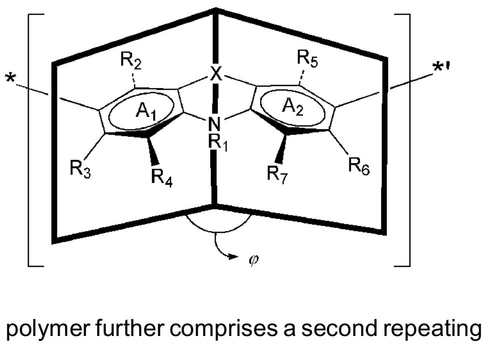

Formula 1-2

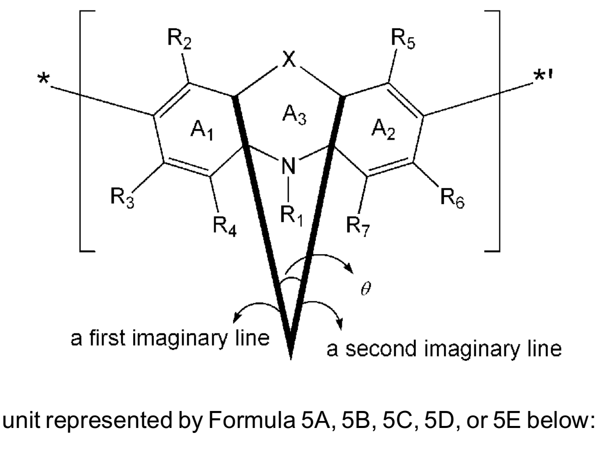


wherein the polymer further comprises a second repeating unit represented by Formula 5A, 5B, 5C, 5D, or 5E below:

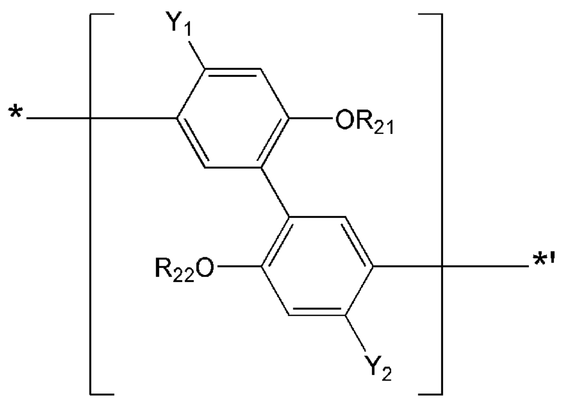

Formula 5A

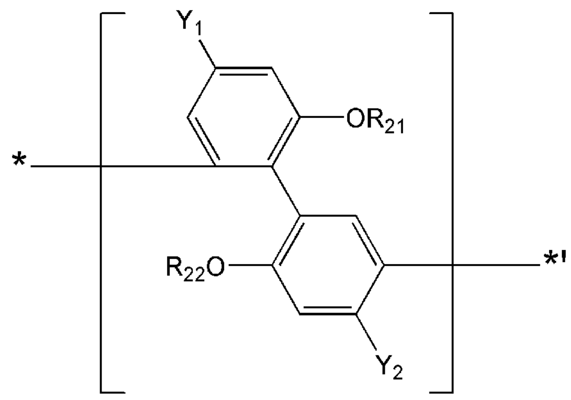

Formula 5B

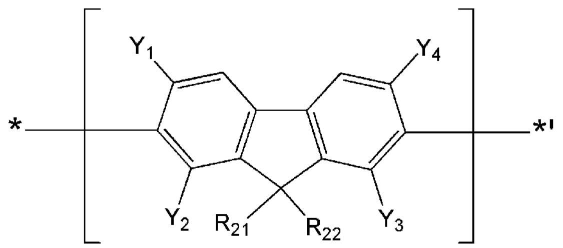

Formula 5C

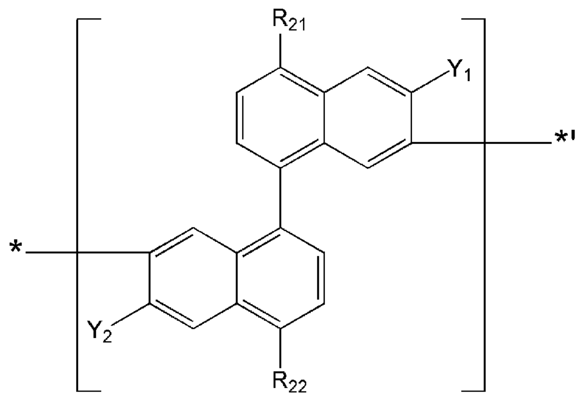

Formula 5D

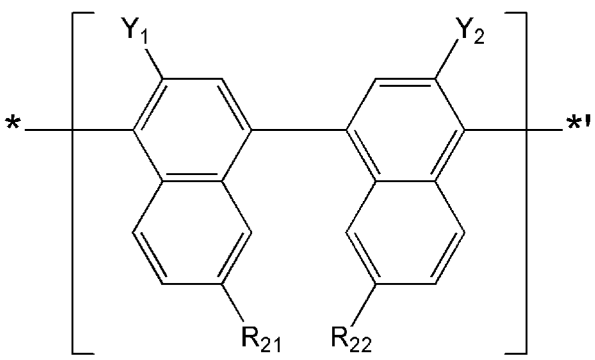

Formula 5E

wherein, in Formulae 5A to 5E, $R_{21}$ and $R_{22}$ are each independently a substituted or unsubstituted $C_1$-$C_{60}$ alkyl group; and

$Y_1$ to $Y_4$ are each independently a hydrogen atom, a substituted or unsubstituted $C_1$-$C_{60}$ alkyl group, or a substituted or unsubstituted $C_1$-$C_{60}$ alkoxy group, or a combination thereof.

**2.** The polymer of claim 1, wherein X is a linker represented by Formula 2 below; $158.37\leq\varphi\leq160.37$; $32.52\leq\theta\leq34.52$; and $38.00\leq\chi_{50\%}\leq40.00$:

Formula 2

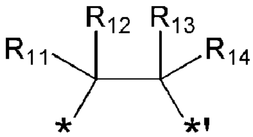

$R_{11}$ to $R_{14}$ of Formula 2 are each independently a hydrogen atom, a deuterium atom, a halogen atom, a hydroxyl group, a cyano group, a nitro group, a carboxyl group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{60}$ cycloalkyl group, a substituted or unsubstituted $C_3$-$C_{60}$ cycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, or a substituted or unsubstituted $C_2$-$C_{60}$ heteroaryl group.

**3.** The polymer of claim 2, wherein $R_{11}$ to $R_{14}$ of Formula 2 are each independently a hydrogen atom; a deuterium atom; F; Cl; a hydroxyl group; a cyano group; a nitro group; a carboxyl group; a methyl group; an ethyl group; a propyl group; an i-propyl group; a butyl group; an i-butyl group; a t-butyl group; a pentyl group; a hexyl group; a heptyl group; an octyl group; a 2-ethylhexyl group; a nonyl group; a decyl group; a 3,7-dimethyloctyl group; a methyl group, an ethyl group, a propyl group, an i-propyl group, a butyl group, an i-butyl group, a t-butyl group, a pentyl group, a hexyl group, a heptyl group, an octyl group, a 2-ethylhexyl group, a nonyl group, a decyl group, and 3,7-dimethyloctyl that are each substituted with at least one of a deuterium atom, F, Cl, a hydroxyl group, a cyano group, a nitro group, and a carboxyl group; a methoxy group; an ethoxy group; a propyloxy group; an i-propyloxy group; a butoxy group; an i-butoxy group; a t-butoxy group; a pentyloxy group; a hexyloxy group; a heptyloxy group; an octyloxy group; a 2-ethylhexyloxy group; a nonyloxy group; a decyloxy group; a 3,7-dimethyloctyloxy group; and a methoxy group, an ethoxy group, a propyloxy group, an i-propyloxy group, a butoxy group, a i-butoxy group, a t-butoxy group, a pentyloxy group, a hexyloxy group, a heptyloxy group, an octyloxy group, a 2-ethylhexyloxy group, a nonyloxy group, a decyloxy group, and a 3,7-dimethyloctyloxy group that are each substituted with at least one of a deuterium atom, F, Cl, a hydroxyl group, a cyano group, a nitro group, and a carboxyl group.

**4.** The polymer of any of claims 1-3, wherein X is a single bond; $\varphi$=180.00; $-34.45 \leq \theta \leq -32.45$; and $27.00 \leq \chi_{50\%} \leq 29.00$.

**5.** The polymer of any of claims 1-3, wherein:

- X is a linker represented by -O-; $167.18 \leq \varphi \leq 169.18$; $-2.81 \leq \theta \leq -0.81$; and $32.00 \leq \chi_{50\%} \leq 34.00$;
- X is a linker represented by -S-; $149.27 \leq \varphi \leq 151.27$; $10.01 \leq \theta \leq 12.01$; and $34.00 \leq \chi_{50\%} \leq 36.00$; or
- X is a linker represented by -Se-;$145.94 \leq \varphi \leq 147.94$; $14.46 \leq \theta \leq 16.46$; and $34.00 \leq \chi_{50\%} \leq 36.00$.

**6.** The polymer of claim 1, wherein, in Formula 1, $R_2$ to $R_7$ are a hydrogen atom, and $R_1$ is represented by Formula 3A, 3B, 3C, 3D, 3E, 3F, 3G, 3H, or 3I below:

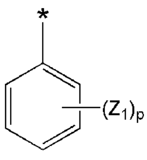

Formula 3A

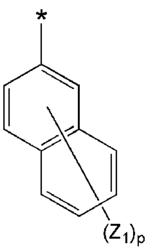

Formula 3B

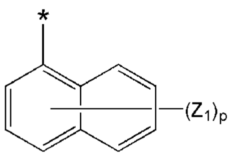

Formula 3C

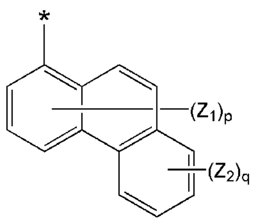

Formula 3D

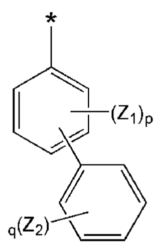

Formula 3E

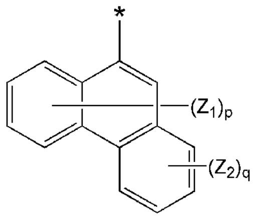

Formula 3F

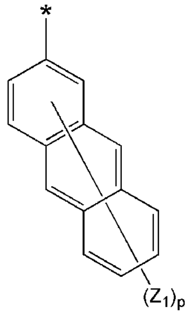

Formula 3G

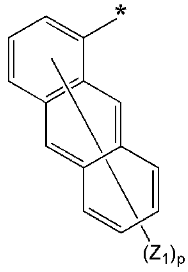

Formula 3H

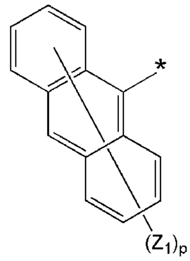

Formula 3I

wherein in Formulae 3A to 3I, $Z_1$ and $Z_2$ are each independently a deuterium atom, a halogen atom, a hydroxyl group, a cyano group, a nitro group, a carboxyl group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{60}$ cycloalkyl group, a substituted or unsubstituted $C_3$-$C_{60}$ cycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, or a substituted or unsubstituted $C_2$-$C_{60}$ heteroaryl group;
p is an integer from 0 to 9; and
q is an integer from 0 to 4;

**7.** The polymer of claim 1, wherein $R_1$ of Formula 1 is represented by Formula 4A below:

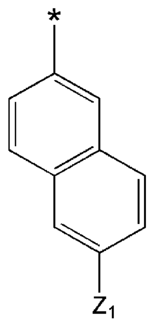

Formula 4A

wherein $Z_1$ of Formula 4A is a deuterium atom; F; Cl; a hydroxyl group; a cyano group; a nitro group; a carboxyl group; a methyl group; an ethyl group; a propyl group; an i-propyl group; a butyl group; an i-butyl group; a t-butyl group; a pentyl group; a hexyl group; a heptyl group; an octyl group; a 2-ethylhexyl group; a nonyl group; a decyl group; a 3,7-dimethyloctyl group; a methyl group, an ethyl group, a propyl group, an i-propyl group, a butyl group, an i-butyl group, a t-butyl group, a pentyl group, a hexyl group, a heptyl group, an octyl group, a 2-ethylhexyl group, a nonyl group, a decyl group, and 3,7-dimethyloctyl that are each substituted with at least one of a deuterium atom, F, Cl, a hydroxyl group, a cyano group, a nitro group, and a carboxyl group; a methoxy group; an ethoxy group; a propyloxy group; an i-propyloxy group; a butoxy group; an i-butoxy group; a t-butoxy group; a pentyloxy group; a hexyloxy group; a heptyloxy group; an octyloxy group; a 2-ethylhexyloxy group; a nonyloxy group; a decyloxy group; a 3,7-dimethyloctyloxy group; and a methoxy group, an ethoxy group, a propyloxy group, an i-propyloxy group, a butoxy group, a i-butoxy group, a t-butoxy group, a pentyloxy group, a hexyloxy group, a heptyloxy group, an octyloxy group, a 2-ethylhexyloxy group, a nonyloxy group, a decyloxy group, and a 3,7-dimethyloctyloxy group that are each substituted with at least one of a deuterium atom, F, Cl, a hydroxyl group, a cyano group, a nitro group, and a carboxyl group.

**8.** The polymer of any of claims 1-7, wherein $R_{21}$ and $R_{22}$ are each independently a methyl group; an ethyl group; a propyl group; an i-propyl group; a butyl group; an i-butyl group; a t-butyl group; a pentyl group; a hexyl group; a heptyl group; an octyl group; a 2-ethylhexyl group; a nonyl group; a decyl group; a 3,7-dimethyloctyl group; and a methyl group, an ethyl group, a propyl group, an i-propyl group, a butyl group, an i-butyl group, a t-butyl group, a

pentyl group, a hexyl group, a heptyl group, an octyl group, a 2-ethylhexyl group, a nonyl group, a decyl group, and a 3,7-dimethyloctyl that are each substituted with at least one of a deuterium atom, F, Cl, a hydroxyl group, a cyano group, a nitro group, and a carboxyl group.

**9.** The polymer of any of claims 1-8, wherein the polymer is an alternating polymer consisting of the first repeating unit and the second repeating unit.

**10.** The polymer of claim 1, wherein the polymer is an alternating polymer consisting of a repeating unit represented by Formula 6A or 6B below.

Formula 6A

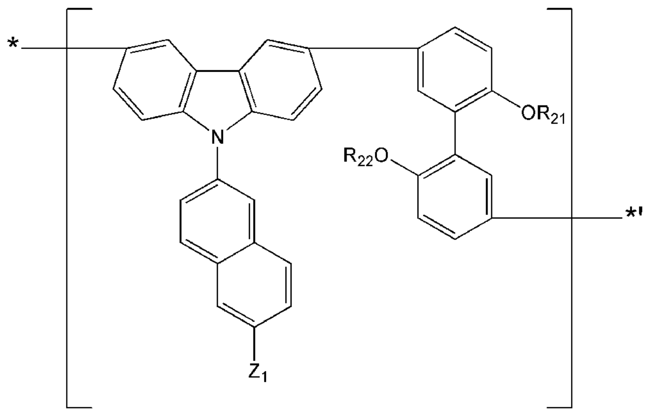

Formula 6B

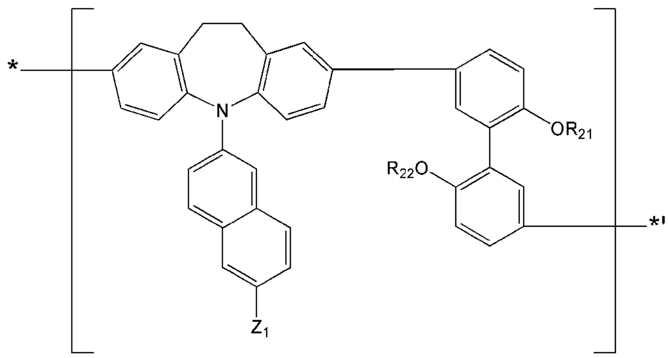

wherein, in Formulae 6A and 6B, $R_{21}$ and $R_{22}$ are each independently a methyl group; an ethyl group; a propyl group; an i-propyl group; a butyl group; an i-butyl group; a t-butyl group; a pentyl group; a hexyl group; a heptyl group; an octyl group; a 2-ethylhexyl group; a nonyl group; a decyl group; a 3,7-dimethyloctyl group; and a methyl group, an ethyl group, a propyl group, an i-propyl group, a butyl group, an i-butyl group, a t-butyl group, a pentyl group, a hexyl group, a heptyl group, an octyl group, a 2-ethylhexyl group, a nonyl group, a decyl group, and a 3,7-dimethyloctyl that are each substituted with at least one of a deuterium atom, F, Cl, a hydroxyl group, a cyano group, a nitro group, and a carboxyl group; and

$Z_1$ is a hydrogen atom; a deuterium atom; F; Cl; a hydroxyl group; a cyano group; a nitro group; a carboxyl group; a methyl group; an ethyl group; a propyl group; an i-propyl group; a butyl group; an i-butyl group; a t-butyl group; a pentyl group; a hexyl group; a heptyl group; an octyl group; a 2-ethylhexyl group; a nonyl group; a decyl group; a 3,7-dimethyloctyl group; a methyl group, an ethyl group, a propyl group, an i-propyl group, a butyl group, an i-butyl group, a t-butyl group, a pentyl group, a hexyl group, a heptyl group, an octyl group, a 2-ethylhexyl group, a nonyl group, a decyl group, and 3,7-dimethyloctyl that are each substituted with at least one of a deuterium atom, F, Cl, a hydroxyl group, a cyano group, a nitro group, and a carboxyl group; a methoxy group; an ethoxy group; a propyloxy group; an i-propyloxy group; a butoxy group; an i-butoxy group; a t-butoxy group; a pentyloxy group; a hexyloxy group; a heptyloxy group; an octyloxy group; a 2-ethylhexyloxy group; a nonyloxy group; a decyloxy group; a 3,7-dimethyloctyloxy group; and a methoxy group, an ethoxy group, a

propyloxy group, an i-propyloxy group, a butoxy group, a i-butoxy group, a t-butoxy group, a pentyloxy group, a hexyloxy group, a heptyloxy group, an octyloxy group, a 2-ethylhexyloxy group, a nonyloxy group, a decyloxy group, and a 3,7-dimethyloctyloxy group that are each substituted with at least one of a deuterium atom, F, Cl, a hydroxyl group, a cyano group, a nitro group, and a carboxyl group.

**11.** An organic light-emitting device comprising a substrate; a first electrode; a second electrode; and a first layer disposed between the first electrode and the second electrode, the first layer comprising the polymer of any of claims 1-10.

**12.** The organic light-emitting device of claim 11, wherein the organic layer is an emission layer and further comprises a phosphorescent dopant, wherein an amount of the phosphorescent dopant in the organic layer preferably is in the range of 1-10 wt% based on a total weight of the organic layer.

**13.** The organic light-emitting device of claim 12, wherein the phosphorescent dopant comprises an organometallic complex including at least one of iridium (Ir), platinum (Pt), osmium (Os), rhenium (Re), titanium (Ti), zirconium (Zr), hafnium (Hf), or a combination of at least two thereof.

## Patentansprüche

**1.** Polymer, umfassend m wiederkehrende Einheiten,
wobei eine n-te wiederkehrende Einheit der m wiederkehrenden Einheiten eine erste wiederkehrende Einheit ist, die nachfolgend durch Formel 1 dargestellt ist,
wobei, wenn sie durch Dichtefunktionaltheorie unter Verwendung der B3LYP-Austauschfunktionalität und eines 6-31+G(d)-Basissatzes geschätzt werden, mindestens einer von einem ersten dihedralen Winkel zwischen einem $A_1$-Ring der n-ten Wiederholungseinheit und einem ersten aromatischen Ring einer (n-1)-ten Wiederholungseinheit und einem zweiten dihedralen Winkel zwischen einem $A_2$-Ring der n-ten Wiederholungseinheit und einem zweiten aromatischen Ring einer (n+1)-ten Wiederholungseinheit gleich oder größer als ein Winkel von $\chi_{50\%}$ ist, dargestellt durch Gleichung 1:

Formel 1

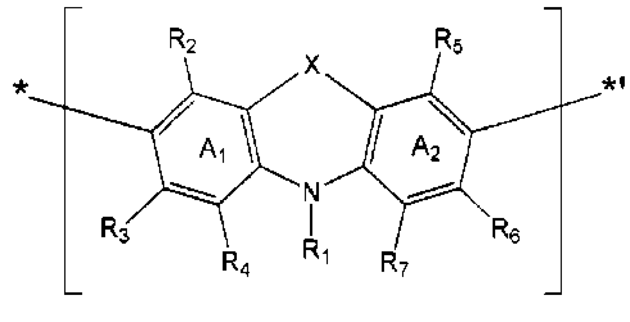

Gleichung 1

$$\chi_{50\%} = A + B(\varphi + 4\theta)$$

wobei der erste aromatische Ring durch eine Einfachbindung an den $A_1$-Ring gebunden ist, der zweite aromatische Ring durch eine Einfachbindung an den $A_2$-Ring gebunden ist,
$R_1$ bis $R_7$ von Formel 1 jeweils unabhängig voneinander eines von einem Wasserstoffatom, einem Deuteriumatom, einem Halogenatom, einer Hydroxylgruppe, einer Nitrilgruppe, einer Nitrogruppe, einer Carboxylgruppe, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkinylgruppe, einer substituierten oder unsubstituierten $C_1$-$C_{60}$-Alkoxygruppe, einer substituierten oder unsubstituierten $C_3$-$C_{60}$-Cycloalkylgruppe, einer substituierten oder unsubstituierten $C_3$-$C_{60}$-Cycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_2$-$C_{60}$-Heteroaryl-Gruppe,

$-N(Q_1)(Q_2)$ und $-Si(Q_3)(Q_4)(Q_5)$ sind, wobei $Q_1$ bis $Q_5$ jeweils unabhängig voneinander ein Wasserstoffatom, ein Deuteriumatom, ein Halogenatom, eine Hydroxylgruppe, eine Nitrilgruppe, eine Nitrogruppe, eine Carboxylgruppe, eine $C_1$-$C_{60}$-Alkylgruppe, eine $C_2$-$C_{60}$-Alkenylgruppe, eine $C_2$-$C_{60}$-Alkinylgruppe, eine $C_3$-$C_{60}$-Cycloalkylgruppe, eine $C_6$-$C_{60}$-Arylgruppe oder eine $C_2$-$C_{60}$-Heteroarylgruppe sind,
X von Formel 1 eine Einfachbindung oder ein Linker mit Kohlenstoff oder einem Element der Gruppe 16 ist,
m eine ganze Zahl von 2 bis 1000 ist,
n eine Variable von 2 bis m-1 ist,
A von Formel 1 26,03 und B 0,0445 ist,
$\varphi$ von Gleichung 1 ein Winkel zwischen dem Ring $A_1$ und dem Ring $A_2$ von Formel 1 ist, wie in Formel 1-1 unten dargestellt, und
$\theta$ von Gleichung 1 ein Winkel zwischen einer ersten gedachten Linie, die sich von einer Bindung zwischen dem $A_1$-Ring und einem $A_3$-Ring von Formel 1 in eine Richtung nahe dem Stickstoff des $A_3$-Rings erstreckt, und einer zweiten gedachten Linie ist, die sich von einer Bindung zwischen dem $A_2$-Ring und dem $A_3$-Ring in eine Richtung nahe dem Stickstoff des $A_3$-Rings erstreckt, wie in Formel 1-2 unten dargestellt:

Formel 1-1

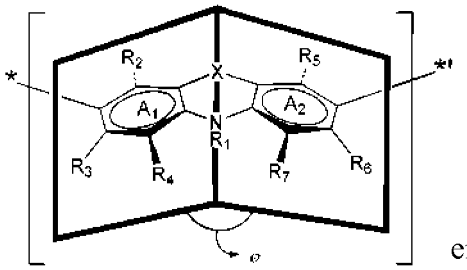

Formel 1-2

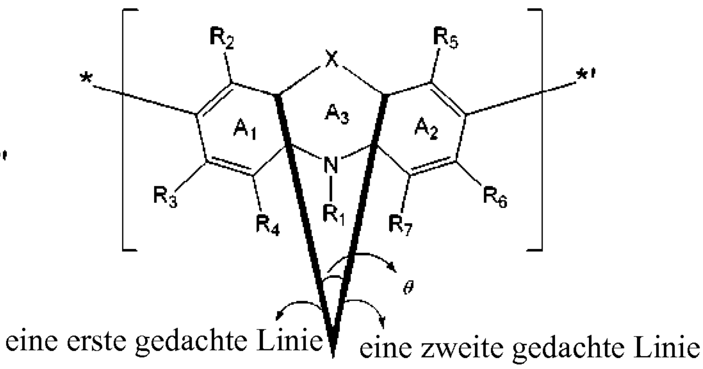


wobei das Polymer ferner eine zweite wiederkehrende Einheit umfasst, die durch nachfolgend durch Formeln 5A, 5B, 5C, 5D oder 5E dargestellt ist:

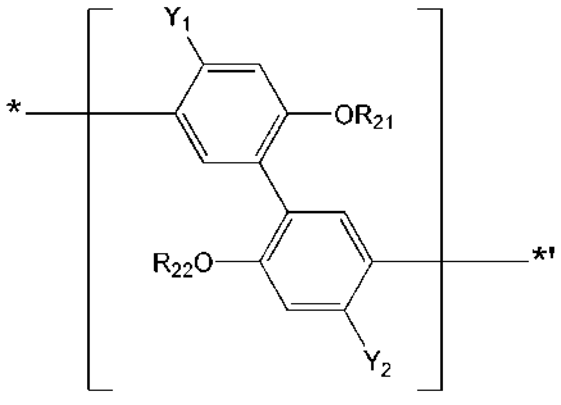

Formel 5A

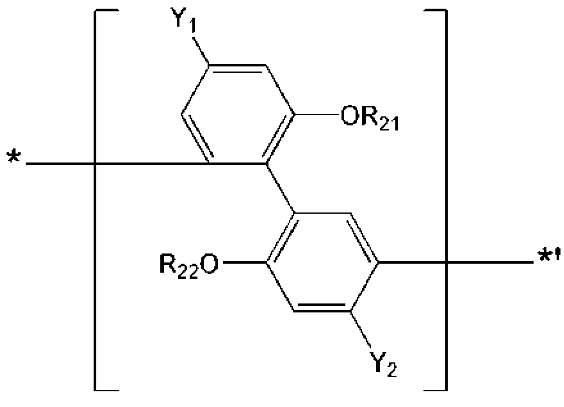

Formel 5B

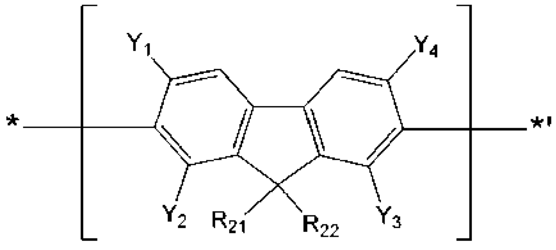

Formel 5C

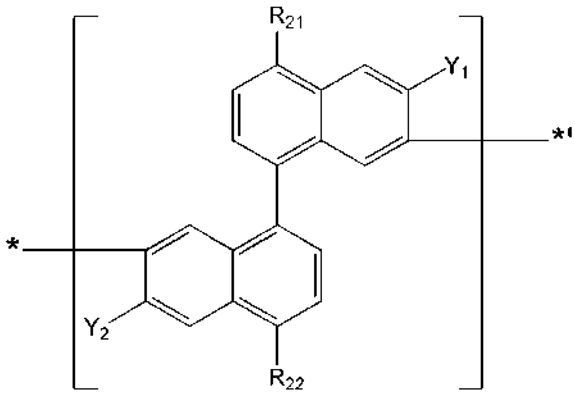

Formel 5D

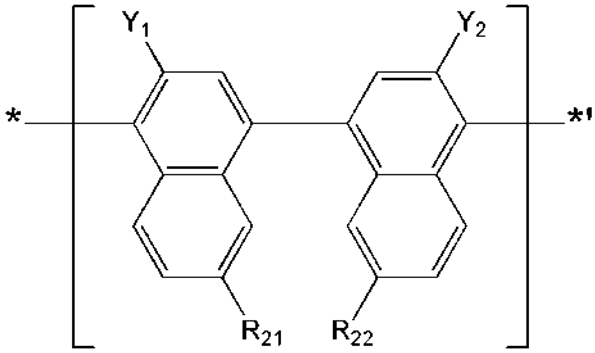

Formel 5E

wobei in den Formeln 5A bis 5E $R_{21}$ und $R_{22}$ jeweils unabhängig voneinander eine substituierte oder unsubstituierte $C_1$-$C_{60}$-Alkylgruppe sind, und
$Y_1$ bis $Y_4$ jeweils unabhängig voneinander ein Wasserstoffatom, eine substituierte oder unsubstituierte $C_1$-$C_{60}$-Alkylgruppe oder eine substituierte oder unsubstituierte $C_1$-$C_{60}$-Alkoxygruppe oder eine Kombination davon sind.

**2.** Polymer nach Anspruch 1, wobei X ein Linker ist, dargestellt nachfolgend durch Formel 2, $158{,}37 \leq \varphi \leq 160{,}37$; $32{,}52 \leq \theta \leq 34{,}52$ und $38{,}00 \leq \chi_{50\%} \leq 40{,}00$:

Formel 2

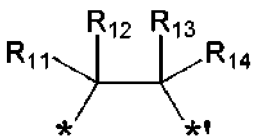

$R_{11}$ bis $R_{14}$ Formel 2 sind jeweils unabhängig voneinander ein Wasserstoffatom, ein Deuteriumatom, ein Halogenatom, eine Hydroxylgruppe, eine Nitrilgruppe, eine Nitrogruppe, eine Carboxylgruppe, eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_3$-$C_{60}$-Cycloalkylgruppe, eine substituierte oder unsubstituierte $C_3$-$C_{60}$-Cycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe oder eine substituierte oder unsubstituierte $C_2$-$C_{60}$-Heteroarylgruppe.

3. Polymer nach Anspruch 2, wobei $R_{11}$ bis $R_{14}$ von Formel 2 jeweils unabhängig voneinander ein Wasserstoffatom, ein Deuteriumatom, F, Cl, eine Hydroxylgruppe, eine Nitrilgruppe, eine Nitrogruppe, eine Carboxylgruppe, eine Methylgruppe, eine Ethylgruppe, eine Propylgruppe, eine i-Propylgruppe, eine Butylgruppe, eine i-Butylgruppe, eine t-Butylgruppe, eine Pentylgruppe, eine Hexylgruppe, eine Heptylgruppe, eine Octylgruppe, eine 2-Ethylhexylgruppe, eine Nonylgruppe, eine Decylgruppe, eine 3,7-Dimethyloctylgruppe, eine Methylgruppe, eine Ethylgruppe, eine Propylgruppe, eine i-Propylgruppe, eine Butylgruppe, eine i-Butylgruppe, eine t-Butylgruppe, eine Pentylgruppe, eine Hexylgruppe, eine Heptylgruppe, eine Octylgruppe, eine 2-Ethylhexylgruppe, eine Nonylgruppe, eine Decylgruppe und 3,7-Dimethyloctyl sind, die jeweils mit mindestens einem von einem Deuteriumatom, F, Cl, einer Hydroxylgruppe, einer Nitrilgruppe, einer Nitrogruppe und einer Carboxylgruppe substituiert sind; eine Methoxygruppe, eine Ethoxygruppe, eine Propyloxygruppe, eine i-Propyloxygruppe, eine Butoxygruppe, eine i-Butoxygruppe, eine t-Butoxygruppe, eine Pentyloxygruppe, eine Hexyloxygruppe, eine Heptyloxygruppe, eine Octyloxygruppe, eine 2-Ethylhexyloxygruppe, eine Nonyloxygruppe, eine Decyloxygruppe, eine 3,7-Dimethyloctyloxygruppe; und eine Methoxygruppe, eine Ethoxygruppe, eine Propyloxygruppe, eine i-Propyloxygruppe, eine Butoxygruppe, eine i-Butoxygruppe, eine t-Butoxygruppe, eine Pentyloxygruppe, eine Hexyloxygruppe, eine Heptyloxygruppe, eine Octyloxygruppe, eine 2-Ethylhexyloxygruppe, eine Nonyloxygruppe, eine Decyloxygruppe und eine 3,7-Dimethyloctyloxygruppe, die jeweils mit mindestens einem von einem Deuteriumatom, F, Cl, einer Hydroxylgruppe, einer Nitrilgruppe, einer Nitrogruppe und einer Carboxylgruppe substituiert sind.

4. Polymer nach einem der Ansprüche 1-3, wobei X eine Einfachbindung ist; $\varphi$=180,00; - 34,45≤$\theta$≤-32,45, und 27,00≤$\chi_{50\%}$≤29,00.

5. Polymer nach einem der Ansprüche 1 -3, wobei:

X ein Linker ist, dargestellt durch -O-, 167,18≤$\varphi$≤169,18, -2,81 ≤$\theta$≤-0,81, und 32,00≤ $\chi_{50\%}$≤34,00,
X ein Linker ist, dargestellt durch -S-, 149,27≤$\varphi$≤151,27, 10,01≤$\theta$≤12,01, und 34,00≤ $\chi_{50\%}$≤36,00, oder
X ein Linker ist, dargestellt durch -Se-, 145,94≤$\varphi$≤147,94, 14,46≤$\theta$≤16,46, und 34,00≤$\chi_{50\%}$≤36,00.

6. Polymer nach Anspruch 1, wobei in Formel 1 $R_2$ bis $R_7$ ein Wasserstoffatom sind und $R_1$ nachfolgend durch die Formeln 3A, 3B, 3C, 3D, 3E, 3F, 3G, 3H oder 3I dargestellt ist:

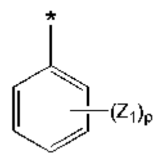
Formel 3A

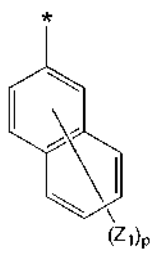
Formel 3B

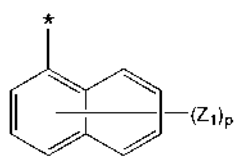
Formel 3C

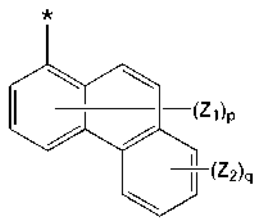
Formel 3D

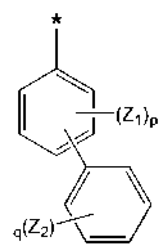
Formel 3E

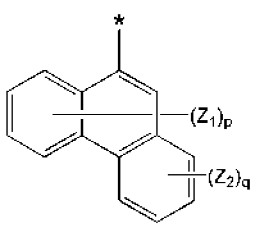
Formel 3F

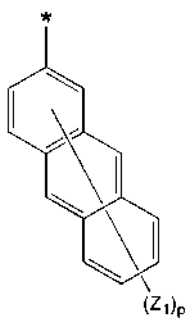
Formel 3G

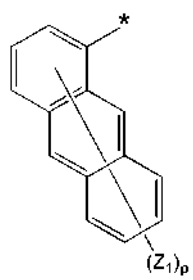
Formel 3H

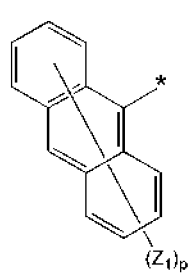
Formel 3I

wobei $Z_1$ und $Z_2$ in Formeln 3A bis 3I jeweils unabhängig voneinander ein Deuteriumatom, ein Halogenatom, eine Hydroxylgruppe, eine Nitrilgruppe, eine Nitrogruppe, eine Carboxylgruppe, eine substituierte oder unsubstituierte $C_1$-$C_{60}$-Alkylgruppe, eine substituierte oder unsubstituierte $C_2$-$C_{60}$-Alkenylgruppe, eine substituierte

oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_3$-$C_{60}$-Cycloalkylgruppe, eine substituierte oder unsubstituierte $C_3$-$C_{60}$-Cycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe oder eine substituierte oder unsubstituierte $C_2$-$C_{60}$-Heteroarylgruppe sind,
p eine ganze Zahl von 0 bis 9 ist und
q eine ganze Zahl von 0 bis 4 ist.

**7.** Polymer nach Anspruch 1, wobei $R_1$ von Formel 1 nachfolgend durch Formel 4A dargestellt ist:

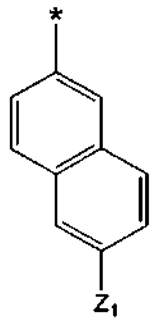

Formel 4A

wobei $Z_1$ von Formel 4A ein Deuteriumatom, F, Cl, eine Hydroxylgruppe, eine Nitrilgruppe, eine Nitrogruppe, eine Carboxylgruppe, eine Methylgruppe, eine Ethylgruppe, eine Propylgruppe, eine i-Propylgruppe, eine Butylgruppe, eine i-Butylgruppe, eine t-Butylgruppe, eine Pentylgruppe, eine Hexylgruppe, eine Heptylgruppe, eine Octylgruppe, eine 2-Ethylhexylgruppe, eine Nonylgruppe, eine Decylgruppe, eine 3,7-Dimethyloctylgruppe, eine Methylgruppe, eine Ethylgruppe, eine Propylgruppe, eine i-Propylgruppe, eine Butylgruppe, eine i-Butylgruppe, eine t-Butylgruppe, eine Pentylgruppe, eine Hexylgruppe, eine Heptylgruppe, eine Octylgruppe, eine 2-Ethylhexylgruppe, eine Nonylgruppe, eine Decylgruppe und 3,7-Dimethyloctyl ist, die jeweils mit mindestens einem von einem Deuteriumatom, F, Cl, einer Hydroxylgruppe, einer Nitrilgruppe, einer Nitrogruppe und einer Carboxylgruppe substituiert sind, eine Methoxygruppe, eine Ethoxygruppe, eine Propyloxygruppe, eine i-Propyloxygruppe, eine Butoxygruppe, eine i-Butoxygruppe, eine t-Butoxygruppe, eine Pentyloxygruppe, eine Hexyloxygruppe, eine Heptyloxygruppe, eine Octyloxygruppe, eine 2-Ethylhexyloxygruppe, eine Nonyloxygruppe, eine Decyloxygruppe, eine 3,7-Dimethyloctyloxygruppe, und eine Methoxygruppe, eine Ethoxygruppe, eine Propyloxygruppe, eine i-Propyloxygruppe, eine Butoxygruppe, eine i-Butoxygruppe, eine t-Butoxygruppe, eine Pentyloxygruppe, eine Hexyloxygruppe, eine Heptyloxygruppe, eine Octyloxygruppe, eine 2-Ethylhexyloxygruppe, eine Nonyloxygruppe, eine Decyloxygruppe und eine 3,7-Dimethyloctyloxygruppe, die jeweils mit mindestens einem von einem Deuteriumatom, F, Cl, einer Hydroxylgruppe, einer Nitrilgruppe, einer Nitrogruppe und einer Carboxylgruppe substituiert sind.

**8.** Polymer nach einem der Ansprüche 1-7, wobei $R_{21}$ und $R_{22}$ jeweils unabhängig voneinander eine Methylgruppe, eine Ethylgruppe, eine Propylgruppe, eine i-Propylgruppe, eine Butylgruppe, eine i-Butylgruppe, eine t-Butylgruppe, eine Pentylgruppe, eine Hexylgruppe, eine Heptylgruppe, eine Octylgruppe, eine 2-Ethylhexylgruppe, eine Nonylgruppe, eine Decylgruppe, eine 3,7-Dimethyloctylgruppe sind, und eine Methylgruppe, eine Ethylgruppe, eine Propylgruppe, eine i-Propylgruppe, eine Butylgruppe, eine i-Butylgruppe, eine t-Butylgruppe, eine Pentylgruppe, eine Hexylgruppe, eine Heptylgruppe, eine Octylgruppe, eine 2-Ethylhexylgruppe, eine Nonylgruppe, eine Decylgruppe und ein 3,7-Dimethyloctyl, die jeweils mit mindestens einem von einem Deuteriumatom, F, Cl, einer Hydroxylgruppe, einer Nitrilgruppe, einer Nitrogruppe und einer Carboxylgruppe substituiert sind.

**9.** Polymer nach einem der Ansprüche 1-8, wobei das Polymer ein aus der ersten wiederkehrenden Einheit und der zweiten wiederkehrenden Einheit bestehendes alternierendes Polymer ist.

**10.** Polymer nach Anspruch 1, wobei das Polymer ein alternierendes Polymer ist, das aus einer wiederkehrenden Einheit besteht, die nachfolgend durch Formel 6A oder 6B dargestellt ist.

Formel 6A

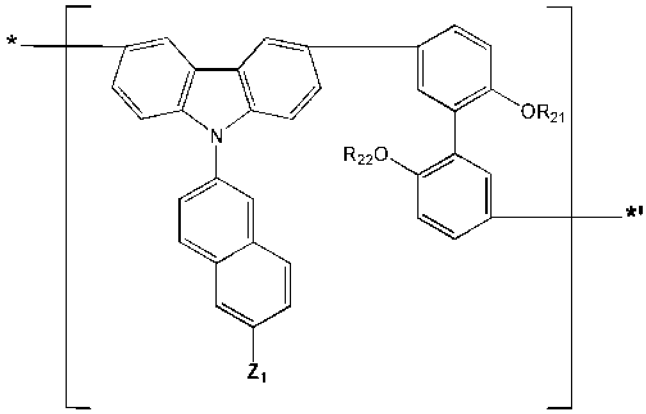

Formel 6B

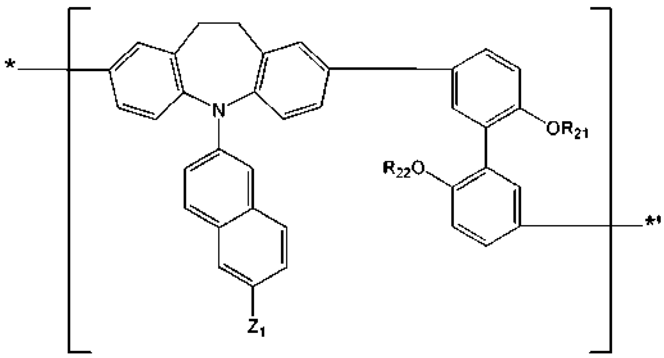

wobei in den Formeln 6A und 6B $R_{21}$ und $R_{22}$ jeweils unabhängig voneinander eine Methylgruppe, eine Ethylgruppe, eine Propylgruppe, eine i-Propylgruppe, eine Butylgruppe, eine i-Butylgruppe, eine t-Butylgruppe, eine Pentylgruppe, eine Hexylgruppe, eine Heptylgruppe, eine Octylgruppe, eine 2-Ethylhexylgruppe, eine Nonylgruppe, eine Decylgruppe, eine 3,7-Dimethyloctylgruppe sind, und eine Methylgruppe, eine Ethylgruppe, eine Propylgruppe, eine i-Propylgruppe, eine Butylgruppe, eine i-Butylgruppe, eine t-Butylgruppe, eine Pentylgruppe, eine Hexylgruppe, eine Heptylgruppe, eine Octylgruppe, eine 2-Ethylhexylgruppe, eine Nonylgruppe, eine Decylgruppe und ein 3,7-Dimethyloctyl, die jeweils mit mindestens einem von einem Deuteriumatom, F, Cl, einer Hydroxylgruppe, einer Nitrilgruppe, einer Nitrogruppe und einer Carboxylgruppe substituiert sind, und

$Z_1$ ein Wasserstoffatom, ein Deuteriumatom, F, Cl, eine Hydroxylgruppe, eine Nitrilgruppe, eine Nitrogruppe, eine Carboxylgruppe, eine Methylgruppe, eine Ethylgruppe, eine Propylgruppe, eine i-Propylgruppe, eine Butylgruppe, eine i-Butylgruppe, eine t-Butylgruppe, eine Pentylgruppe, eine Hexylgruppe, eine Heptylgruppe, eine Octylgruppe, eine 2-Ethylhexylgruppe, eine Nonylgruppe, eine Decylgruppe, eine 3,7-Dimethyloctylgruppe, eine Methylgruppe, eine Ethylgruppe, eine Propylgruppe, eine i-Propylgruppe, eine Butylgruppe, eine i-Butylgruppe, eine t-Butylgruppe, eine Pentylgruppe, eine Hexylgruppe, eine Heptylgruppe, eine Octylgruppe, eine 2-Ethylhexylgruppe, eine Nonylgruppe, eine Decylgruppe und 3,7-Dimethyloctyl ist, die jeweils mit mindestens einem von einem Deuteriumatom, F, Cl, einer Hydroxylgruppe, einer Nitrilgruppe, einer Nitrogruppe und einer Carboxylgruppe substituiert sind, eine Methoxygruppe, eine Ethoxygruppe, eine Propyloxygruppe, eine i-Propyloxygruppe, eine Butoxygruppe, eine i-Butoxygruppe, eine t-Butoxygruppe, eine Pentyloxygruppe, eine Hexyloxygruppe, eine Heptyloxygruppe, eine Octyloxygruppe, eine 2-Ethylhexyloxygruppe, eine Nonyloxygruppe, eine Decyloxygruppe, eine 3,7-Dimethyloctyloxygruppe, und eine Methoxygruppe, eine Ethoxygruppe, eine Propyloxygruppe, eine i-Propyloxygruppe, eine Butoxygruppe, eine i-Butoxygruppe, eine t-Butoxygruppe, eine Pentyloxygruppe, eine Hexyloxygruppe, eine Heptyloxygruppe, eine Octyloxygruppe, eine 2-Ethylhexyloxygruppe, eine Nonyloxygruppe, eine Decyloxygruppe und eine 3,7-Dimethyloctyloxygruppe, die jeweils mit mindestens einem von einem Deuteriumatom, F, Cl, einer Hydroxylgruppe, einer Nitrilgruppe, einer Nitrogruppe und einer Carboxylgruppe substituiert sind.

**11.** Organische lichtemittierende Vorrichtung, umfassend ein Substrat, eine erste Elektrode, eine zweite Elektrode und eine erste Schicht, die zwischen der ersten Elektrode und der zweiten Elektrode angeordnet ist, wobei die erste

Schicht das Polymer nach einem der Ansprüche 1 bis 10 umfasst.

**12.** Organische lichtemittierende Vorrichtung nach Anspruch 11, wobei die organische Schicht eine Emissionsschicht ist und ferner ein phosphoreszierendes Dotiermittel umfasst, wobei eine Menge des phosphoreszierenden Dotiermittels in der organischen Schicht vorzugsweise im Bereich von 1 bis 10 % Massenanteil liegt, bezogen auf eine Gesamtmasse der organischen Schicht.

**13.** Organische lichtemittierende Vorrichtung nach Anspruch 12, wobei das phosphoreszierende Dotiermittel einen metallorganischen Komplex umfasst, der mindestens eines von Iridium (Ir), Platin (Pt), Osmium (Os), Rhenium (Re), Titan (Ti), Zirkonium (Zr), Hafnium (Hf) oder eine Kombination von mindestens zwei davon beinhaltet.

**Revendications**

**1.** Polymère comprenant m unités répétitives, dans lequel une $n^{ième}$ unité répétitive des m unités répétitives est une première unité répétitive représentée par la formule 1 ci-dessous, dans lequel, lorsqu'il est estimé par la théorie de la fonctionnelle de la densité en utilisant la fonctionnelle d'échange B3LYP et un ensemble de base 6-31+G(d), au moins l'un d'un premier angle dièdre entre un anneau $A_1$ de la $n^{ième}$ unité répétitive et un premier anneau aromatique d'une $(n-1)^{ième}$ unité répétitive et un deuxième angle dièdre entre un anneau $A_2$ de la $n^{ième}$ unité répétitive et un deuxième anneau aromatique d'une $(n+1)^{ième}$ unité répétitive est égal ou supérieur à un angle de $X_{50\%}$ représenté par l'équation 1 :

Formule 1

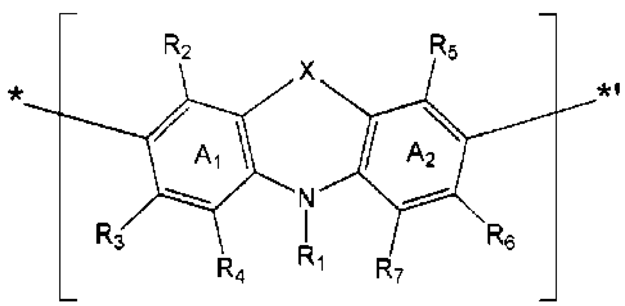

Équation 1

$$X_{50\,\%} = A + B(\varphi + 4\theta)$$

où le premier anneau aromatique est lié à l'anneau $A_1$ par une liaison simple ;
le deuxième anneau aromatique est lié à l'anneau $A_2$ par une liaison simple ;
$R_1$ à $R_7$ de la formule 1 sont chacun indépendamment l'un d'un atome hydrogène, un atome déuterium, un atome halogène, un groupe hydroxyle, un groupe cyano, un groupe nitro, un groupe carboxyle, un groupe alkyle $C_1$-$C_{60}$ substitué ou non substitué, un groupe alkenyle $C_2$-$C_{60}$ substitué ou non substitué, un groupe alkynyle $C_2$-$C_{60}$ substitué ou non substitué, un groupe alkoxy $C_1$-$C_{60}$ substitué ou non substitué, un groupe cycloalkyle $C_3$-$C_{60}$ substitué ou non substitué, un groupe cycloalkenyle $C_3$-$C_{60}$ substitué ou non substitué, un groupe aryle $C_6$-$C_{60}$ substitué ou non substitué, un groupe aryloxy $C_6$-$C_{60}$ substitué ou non substitué, un groupe arylthio $C_6$-$C_{60}$ substitué ou non substitué, un groupe hétéroaryle $C_2$-$C_{60}$ substitué ou non substitué, $-N(Q_1)(Q_2)$, et $-Si(Q_3)(Q_4)(Q_5)$, où $Q_1$ à $Q_5$ sont chacun indépendamment un atome hydrogène, un atome déuterium, un atome halogène, un groupe hydroxyle, un groupe cyano, un groupe nitro, un groupe carboxyle, un groupe alkyle $C_1$-$C_{60}$, un groupe alkenyle $C_2$-$C_{60}$, un groupe alkynyle $C_2$-$C_{60}$, un groupe cycloalkyle $C_3$-$C_{60}$, un groupe aryle $C_6$-$C_{60}$, ou un groupe hétéroaryle $C_2$-$C_{60}$ ;
X de la formule 1 est une liaison simple, ou un lieur incluant du carbone ou un élément du Groupe 16;
m est un nombre entier de 2 à 1000 ;
n est une variable de 2 à m-1 ;
A de la formule 1 est 26,03 ; et B est 0,0445 ;
$\varphi$ de l'équation 1 est un angle entre l'anneau $A_1$ et l'anneau $A_2$ de la formule 1, comme illustré sur la formule

1-1 ci-dessous ; et

$\theta$ de l'équation 1 est un angle entre une première ligne imaginaire s'étendant depuis une liaison entre l'anneau $A_1$ et un anneau $A_3$ de la formule 1 dans une direction proche de l'azote de l'anneau $A_3$ et une deuxième ligne imaginaire s'étendant depuis une liaison entre l'anneau $A_2$ et l'anneau $A_3$ dans une direction proche de l'azote de l'anneau $A_3$, comme illustré dans la formule 1-2 ci-dessous :

Formule 1-1

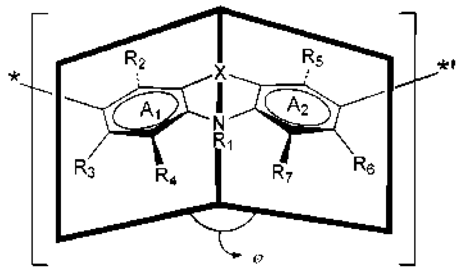

Formule 1-2

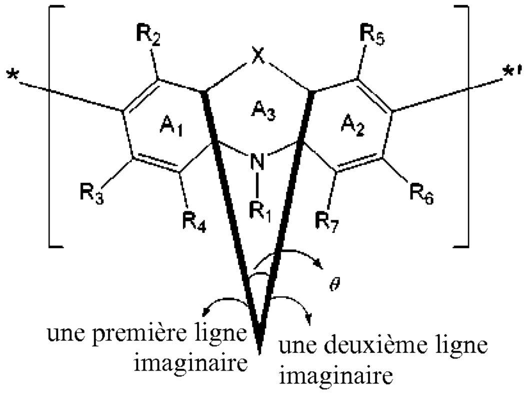


où le polymère comprend en outre une deuxième unité répétitive représentée par la formule 5A, 5B, 5C, 5D, ou 5E ci-dessous :

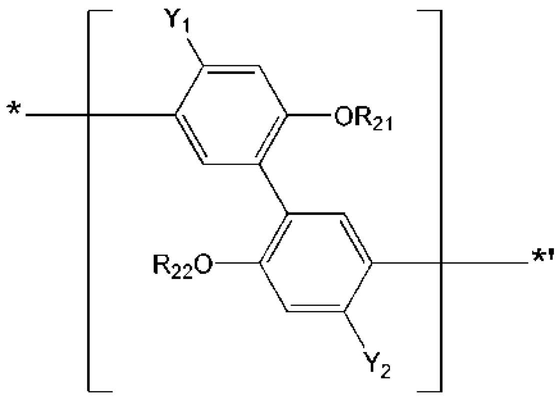

Formule 5A

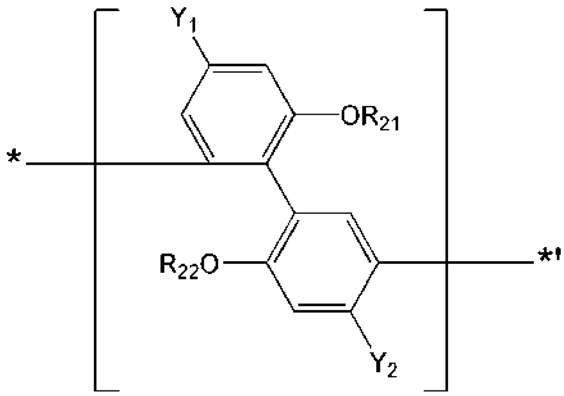

Formule 5B

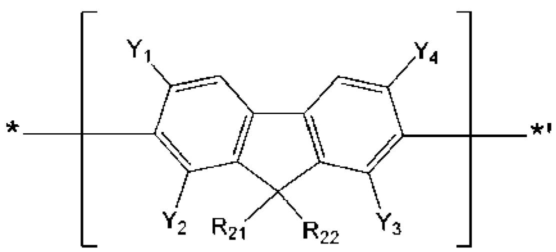

Formule 5C

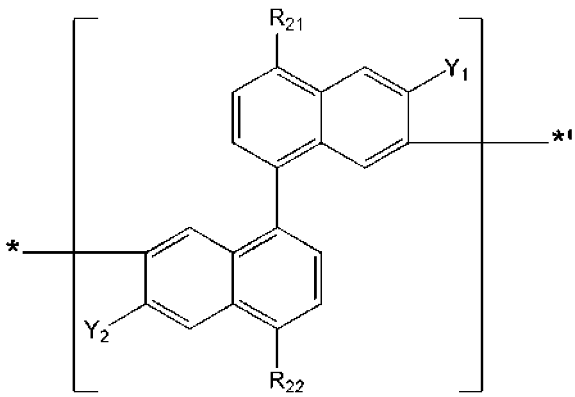

Formule 5D

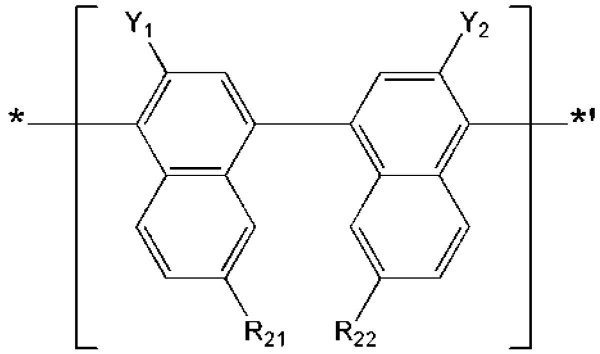

Formule 5E

où, dans les formules 5A à 5E, $R_{21}$ et $R_{22}$ sont chacun indépendamment un groupe alkyle $C_1$-$C_{60}$ substitué ou non substitué ; et

$Y_1$ à $Y_4$ sont chacun indépendamment un atome hydrogène, un groupe alkyle $C_1$-$C_{60}$substitué ou non substitué, ou un groupe alkoxy $C_1$-$C_{60}$ substitué ou non substitué, ou une combinaison de ceux-ci.

**2.** Polymère selon la revendication 1, dans lequel X est un lieur représenté par la formule 2 ci-dessous ; $158,37 \leq \varphi \leq 160,37$ ; $32,52 \leq \theta \leq 34,52$ ; et $38,00 \leq X_{50\%} \leq 40,00$ :

Formule 2

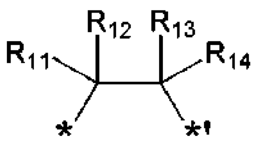

$R_{11}$ à $R_{14}$ de la formule 2 sont chacun indépendamment un atome hydrogène, un atome déuterium, un atome halogène, un groupe hydroxyle, un groupe cyano, un groupe nitro, un groupe carboxyle, un groupe alkyl $C_1$-$C_{60}$ substitué ou non substitué, un groupe alkenyle $C_2$-$C_{60}$ substitué ou non substitué, un groupe alkynyle $C_2$-$C_{60}$ substitué ou non substitué, un groupe alkoxy $C_1$-$C_{60}$ substitué ou non substitué, un groupe cycloalkyle $C_3$-$C_{60}$ substitué ou non substitué, un groupe cycloalkenyle $C_3$-$C_{60}$ substitué ou non substitué, un groupe aryle $C_6$-$C_{60}$ substitué ou non substitué, un groupe aryloxy $C_6$-$C_{60}$ substitué ou non substitué, un groupe arylthio $C_6$-$C_{60}$ substitué ou non substitué, ou un groupe hétéroaryle $C_2$- $C_{60}$ substitué ou non substitué.

**3.** Polymère selon la revendication 2, dans lequel $R_{11}$ à $R_{14}$ de la formule 2 sont chacun indépendamment un atome hydrogène ; un atome déuterium ; F ; Cl; un groupe hydroxyle ; un groupe cyano ; un groupe nitro ; un groupe carboxyle ; un groupe méthyle ; un groupe éthyle ; un groupe propyle ; un groupe i-propyle ; un groupe butyle ; un groupe i-butyle ; un groupe t-butyle ; un groupe pentyle ; un groupe hexyle ; un groupe héptyle ; un groupe octyle ; un groupe 2-éthylhexyle ; un groupe nonyle ; un groupe décyle ; un groupe 3,7- diméthyloctyle ; un groupe méthyle, un groupe éthyle, un groupe propyle, un groupe i-propyle, un groupe butyle, un groupe i-butyle, un groupe t-butyle, un groupe pentyle, un groupe hexyle, un groupe heptyle, un groupe octyle, un groupe 2-éthylhexyle, un groupe nonyle, un groupe décyle, et 3,7- diméthyloctyle qui sont chacun substitué par au moins l'un d'un atome déuterium, F, Cl, un groupe hydroxyle, un groupe cyano, un groupe nitro, et un groupe carboxyle ; un groupe méthoxy ; un groupe éthoxy ; un groupe propyloxy ; un groupe i-propyloxy ; un groupe butoxy ; un groupe i-butoxy ; un groupe t-butoxy ; un groupe pentyloxy ; un groupe hexyloxy ; un groupe heptyloxy ; un groupe octyloxy ; un groupe 2-éthylhexyloxy ; un groupe nonyloxy ; un groupe décyloxy ; un groupe 3,7-diméthyloctyloxy, et un groupe méthoxy, un groupe éthoxy, un groupe propyloxy, un groupe i-propyloxy, un groupe butoxy, un groupe i-butoxy, un groupe t-butoxy, un groupe pentyloxy, un groupe hexyloxy, un groupe heptyloxy, un groupe octyloxy, un groupe 2-éthylhexyloxy, un groupe nonyloxy, un groupe décyloxy, et un groupe 3,7-diméthyloctyloxy qui sont chacun substitué par au moins l'un d'un atome déuterium, F, Cl, un groupe hydroxyle, un groupe cyano, un groupe nitro et un groupe carboxyle.

**4.** Polymère selon l'une quelconque des revendications 1 à 3, où X est une liaison simple ; $\varphi$=180,00 ; $-34,45 \leq \theta \leq -32,45$ ; et $27,00 \leq X_{50\%} \leq 29,00$.

**5.** Polymère selon l'une quelconque des revendications 1 à 3, dans lequel :

- X est un lieur représenté par -O- ; $167{,}18 \leq \varphi \leq 169{,}18$ ; $-2{,}81 \leq \theta \leq -0{,}81$ ; et $32{,}00 \leq X_{50\%} \leq 34{,}00$ ;
- X est un lieur représenté par -S- ; $149{,}27 \leq \varphi \leq 151{,}27$ ; $10{,}01 \leq \theta \leq 12{,}01$ ; et $34{,}00 \leq X_{50\%} \leq 36{,}00$ ; ou
- X est un lieur représenté par -Se- ; $145{,}94 \leq \varphi \leq 147{,}94$ ; $14{,}46 \leq \theta \leq 16{,}46$ ; et $34{,}00 \leq X_{50\%} \leq 36{,}00$.

**6.** Polymère selon la revendication 1, dans lequel, dans la formule 1, $R_2$ à $R_7$ sont un atome hydrogène, et $R_1$ est représenté par la formule 3A, 3B, 3C, 3D, 3E, 3F, 3G, 3H, ou 3I ci-dessous :

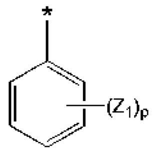
Formule 3A

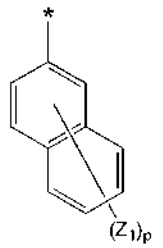
Formule 3B

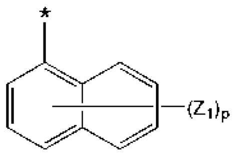
Formule 3C

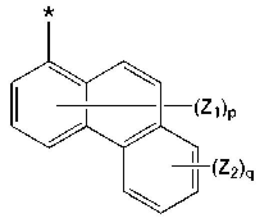
Formule 3D

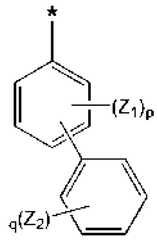
Formule 3E

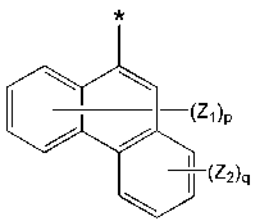
Formule 3F

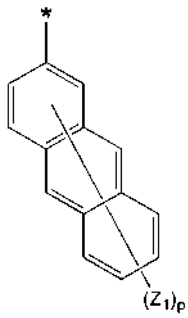
Formule 3G

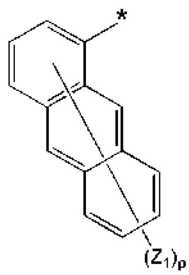
Formule 3H

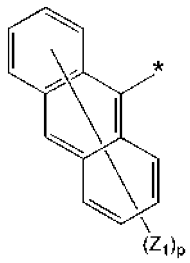
Formule 3I

où dans les formules 3A à 3I, $Z_1$ et $Z_2$ sont chacun indépendamment un atome déuterium, un atome halogène, un groupe hydroxyle, un groupe cyano, un groupe nitro, un groupe carboxyle, un groupe alkyl $C_1$-$C_{60}$ substitué ou non substitué, un groupe alkenyle $C_2$-$C_{60}$ substitué ou non substitué, un groupe alkynyle $C_2$-$C_{60}$ substitué ou non substitué, un groupe alkoxy $C_1$-$C_{60}$ substitué ou non substitué, un groupe cycloalkyle $C_3$-$C_{60}$ substitué ou non substitué, un groupe cycloalkenyle $C_3$-$C_{60}$ substitué ou non substitué, un groupe aryle $C_6$-$C_{60}$ substitué ou non substitué, un groupe aryloxy $C_6$-$C_{60}$ substitué ou non substitué, un groupe arylthio $C_6$-$C_{60}$ substitué ou non substitué, ou un groupe hétéroaryle $C_2$- $C_{60}$ substitué ou non substitué ;
p est un nombre entier de 0 à 9 ; et
q est un nombre entier de 0 à 4.

**7.** Polymère selon la revendication 1, dans lequel $R_1$ de la formule 1 est représenté par la formule 4A ci-dessous :

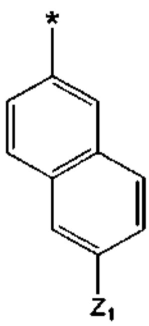
Formule 4A

où $Z_1$ de la formule 4A est un atome déuterium ; F ; Cl; un groupe hydroxyle ; un groupe cyano ; un groupe nitro ; un groupe carboxyle ; un groupe méthyle ; un groupe éthyle ; un groupe propyle ; un groupe i-propyle ; un groupe butyle ; un groupe i-butyle ; un groupe t-butyle ; un groupe pentyle ; un groupe hexyle ; un groupe héptyle ; un groupe octyle ; un groupe 2-éthylhexyle ; un groupe nonyle ; un groupe décyle ; un groupe 3,7- diméthyloctyle ; un groupe méthyle, un groupe éthyle, un groupe propyle, un groupe i-propyle, un groupe butyle, un groupe i-butyle, un groupe t-butyle, un groupe pentyle, un groupe hexyle, un groupe heptyle, un groupe octyle, un groupe 2-éthylhexyle, un groupe nonyle, un groupe décyle, et 3,7- diméthyloctyle qui sont chacun substitué par au moins l'un d'un atome déuterium, F, Cl, un groupe hydroxyle, un groupe cyano, un groupe nitro, et un groupe carboxyle ; un groupe méthoxy ; un groupe éthoxy ; un groupe propyloxy ; un groupe i-propyloxy ; un groupe butoxy ; un groupe i-butoxy ; un groupe t-butoxy ; un groupe pentyloxy ; un groupe hexyloxy ; un groupe heptyloxy ; un groupe octyloxy ; un groupe 2-éthylhexyloxy ; un groupe nonyloxy ; un groupe décyloxy ; un groupe 3,7-diméthyloctyloxy ; et un groupe méthoxy, un groupe éthoxy, un groupe propyloxy, un groupe i-propyloxy, un groupe butoxy, un groupe i-butoxy, un groupe t-butoxy, un groupe pentyloxy, un groupe hexyloxy, un groupe heptyloxy, un groupe octyloxy, un groupe 2-éthylhexyloxy, un groupe nonyloxy, un groupe décyloxy, et un groupe 3,7-diméthyloctyloxy qui sont chacun substitué par au moins l'un d'un atome déuterium, F, Cl, un groupe hydroxyle, un groupe cyano, un groupe nitro et un groupe carboxyle.

**8.** Polymère selon l'une quelconque des revendications 1 à 7, dans lequel $R_{21}$ et $R_{22}$ sont chacun indépendamment un groupe méthyle ; un groupe éthyle ; un groupe propyle ; un groupe i-propyle ; un groupe butyle ; un groupe i-butyle ; un groupe t-butyle ; un groupe pentyle ; un groupe hexyle ; un groupe heptyle ; un groupe octyle ; un groupe 2-éthylhexyle ; un groupe nonyle ; un groupe décyle ; et un groupe 3,7-diméthyloctyle; et un groupe méthyle, un groupe éthyle, un groupe propyle, un groupe i-propyle, un groupe butyle, un groupe i-butyle, un groupe t-butyle, un groupe pentyle, un groupe héxyle, un groupe héptyle, un groupe octyle, un groupe 2-éthylhexyle, un groupe nonyle, un groupe décyle, et un 3,7-diméthyloctyle qui sont chacun substitué par au moins l'un d'un atome déuterium, F, Cl, un groupe hydroxyle, un groupe cyano, un groupe nitro, et un groupe carboxyle.

**9.** Polymère selon l'une quelconque des revendications 1 à 8, dans lequel le polymère un polymère alterné constitué de la première unité répétitive et de la deuxième unité répétitive.

**10.** Polymère selon la revendication 1, dans lequel le polymère un polymère alterné constitué d'une unité répétitive représentée par la formule 6A ou 6B ci-dessous.

Formule 6A

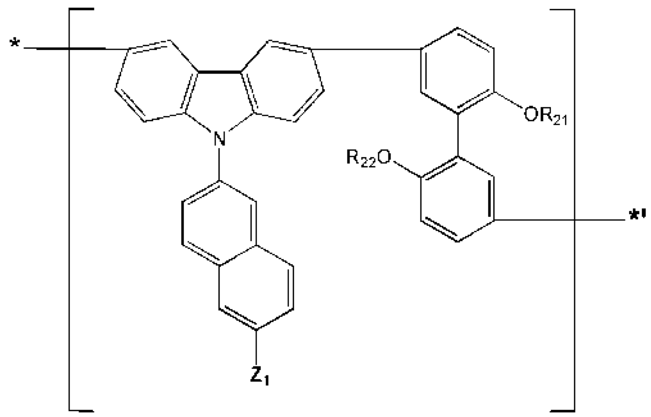

Formule 6B

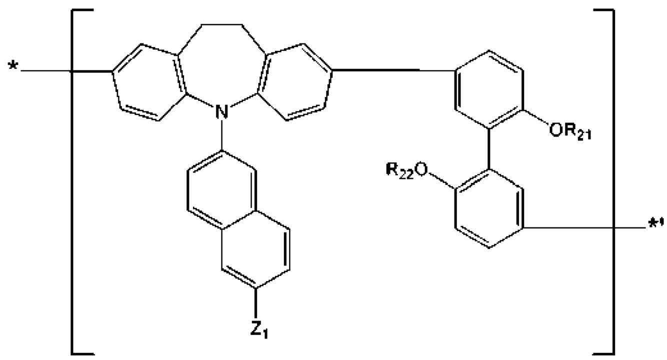

dans lequel, dans les formules 6A et 6B, $R_{21}$ et $R_{22}$ sont chacun indépendamment un groupe méthyle ; un groupe éthyle ; un groupe propyle ; un groupe i-propyle ; un groupe butyle ; un groupe i-butyle ; un groupe t-butyle ; un groupe pentyle ; un groupe hexyle ; un groupe heptyle ; un groupe octyle ; un groupe 2-éthylhexyle ; un groupe nonyle ; un groupe décyle ; un groupe 3,7-diméthyloctyle ; et un groupe méthyle, un groupe éthyle, un groupe propyle, un groupe i-propyle, un groupe butyle, un groupe i-butyle, un groupe t-butyle, un groupe pentyle, un groupe hexyle, un groupe heptyle, un groupe octyle, un groupe 2-éthylhexyle, un groupe nonyle, un groupe décyle, un 3,7-diméthyloctyle qui sont chacun substitué par au moins l'un d'un atome déuterium, F, Cl, un groupe hydroxyle, un groupe cyano, un groupe nitro, et un groupe carboxyle ; et

$Z_1$ est un atome hydrogène ; un atome déuterium ; F ; Cl; un groupe hydroxyle ; un groupe cyano ; un groupe nitro ; un groupe carboxyle ; un groupe méthyle ; un groupe éthyle ; un groupe propyle ; un groupe i-propyle ; un groupe butyle ; un groupe i-butyle ; un groupe t-butyle ; un groupe pentyle ; un groupe hexyle ; un groupe héptyle ; un groupe octyle ; un groupe 2-éthylhexyle ; un groupe nonyle ; un groupe décyle ; un groupe 3,7-diméthyloctyle ; un groupe méthyl, un groupe éthyle, un groupe propyle, un groupe i-propyle, un groupe butyle, un groupe i-butyle, un groupe t-butyle, un groupe pentyle, un groupe hexyle, un groupe heptyle, un groupe octyle, un groupe 2-éthylhexyle, un groupe nonyle, un groupe décyle, et 3,7- diméthyloctyle qui sont chacun substitué par au moins l'un d'un atome déuterium, F, Cl, un groupe hydroxyle, un groupe cyano, un groupe nitro, et un groupe carboxyle ; un groupe méthoxy ; un groupe éthoxy ; un groupe propyloxy ; un groupe i-propyloxy ; un groupe butoxy ; un groupe i-butoxy ; un groupe t-butoxy ; un groupe pentyloxy ; un groupe hexyloxy ; un groupe heptyloxy ; un groupe octyloxy ; un groupe 2-éthylhexyloxy ; un groupe nonyloxy ; un groupe décyloxy ; un groupe 3,7-diméthyloctyloxy ; et un groupe méthoxy, un groupe éthoxy, un groupe propyloxy, un groupe i- propyloxy, un groupe butoxy, un groupe i-butoxy, un groupe t-butoxy, un groupe pentyloxy, un groupe hexyloxy, un groupe heptyloxy, un groupe octyloxy, un groupe 2-éthylhexyloxy, un groupe nonyloxy, un groupe décyloxy, et un groupe 3,7-diméthyloctyloxy qui sont chacun substitué par au moins l'un d'un atome déuterium, F, Cl, un groupe hydroxyle, un groupe cyano, un groupe nitro et un groupe carboxyle.

**11.** Dispositif électroluminescent organique comprenant un substrat ; une première électrode ; une deuxième électrode ; et une première couche disposée entre la première électrode et la deuxième électrode, la première couche comprenant le polymère selon l'une quelconque des revendications 1 à 10.

**12.** Dispositif électroluminescent organique selon la revendication 11, dans lequel la couche organique est une couche d'émission et comprend en outre un dopant phosphorescent, dans lequel une quantité de dopant phosphorescent dans la couche organique est de préférence dans la plage de 1 à 10 % massique sur la base du poids total de la couche organique.

**13.** Dispositif électroluminescent organique selon la revendication 12, dans lequel le dopant phosphorescent comprend un complexe organométallique incluant au moins l'un parmi l'iridium (Ir), le platine (Pt), l'osmium (Os), le rhénium (Re), le titane (Ti), le zirconium (Zr), l'hafnium (Hf), ou une combinaison d'au moins deux de ceux-ci.

FIG. 1

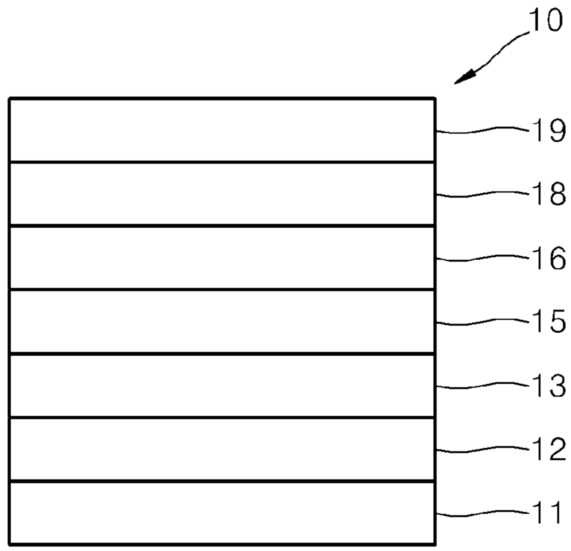

FIG. 2

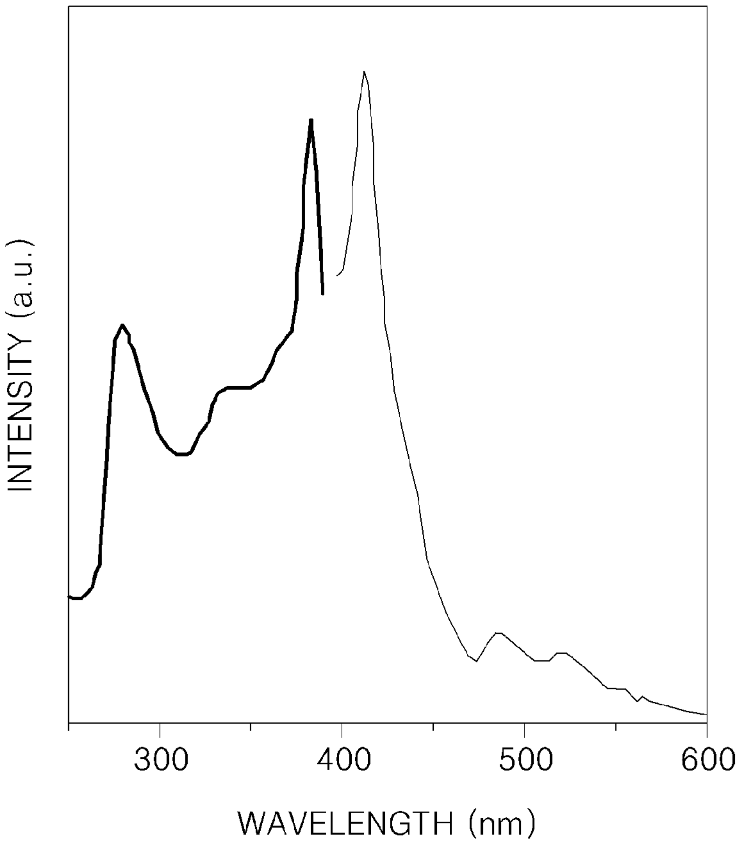

FIG. 3

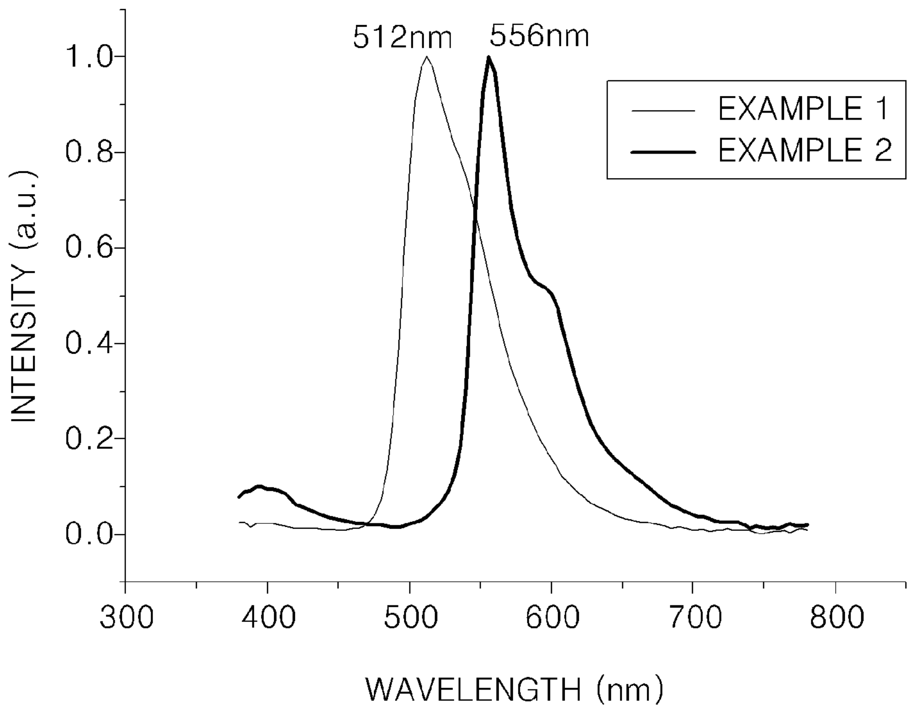
512nm
556nm
EXAMPLE 1
EXAMPLE 2
INTENSITY (a.u.)
1.0
0.8
0.6
0.4
0.2
0.0
300
400
500
600
700
800
WAVELENGTH (nm)

FIG. 4

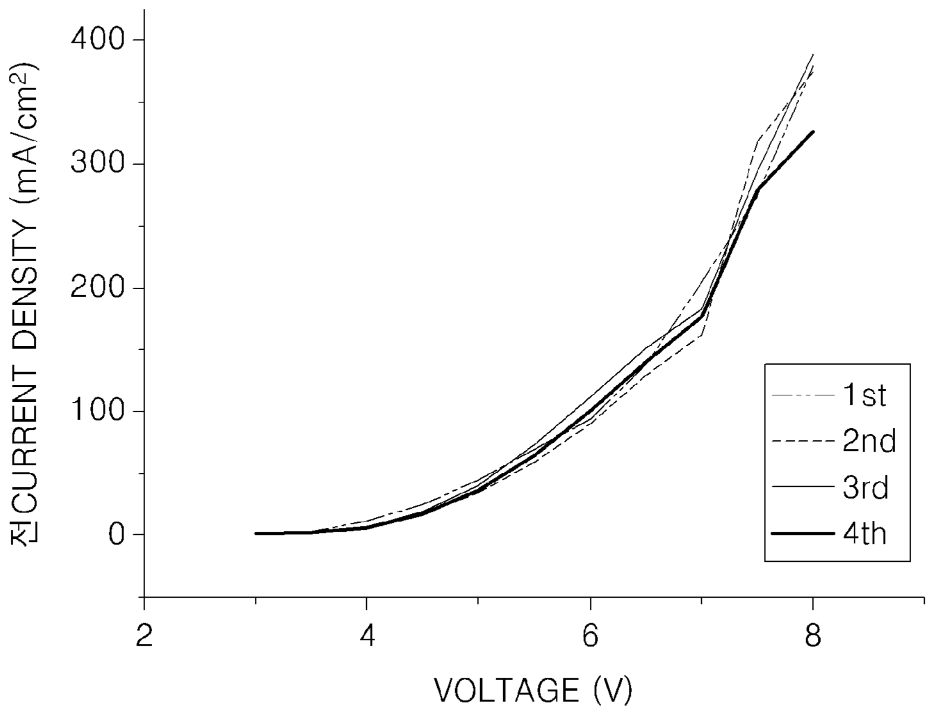
400
300
200
100
0
2
4
6
8
전CURRENT DENSITY (mA/cm2)
VOLTAGE (V)
1st
2nd
3rd
4th

FIG. 5

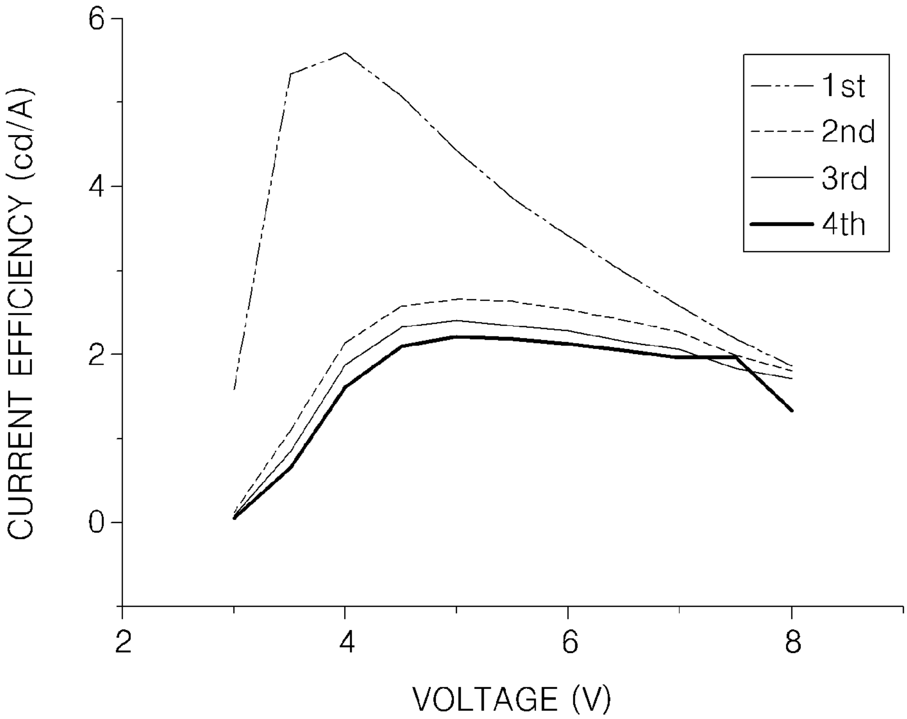

FIG. 6

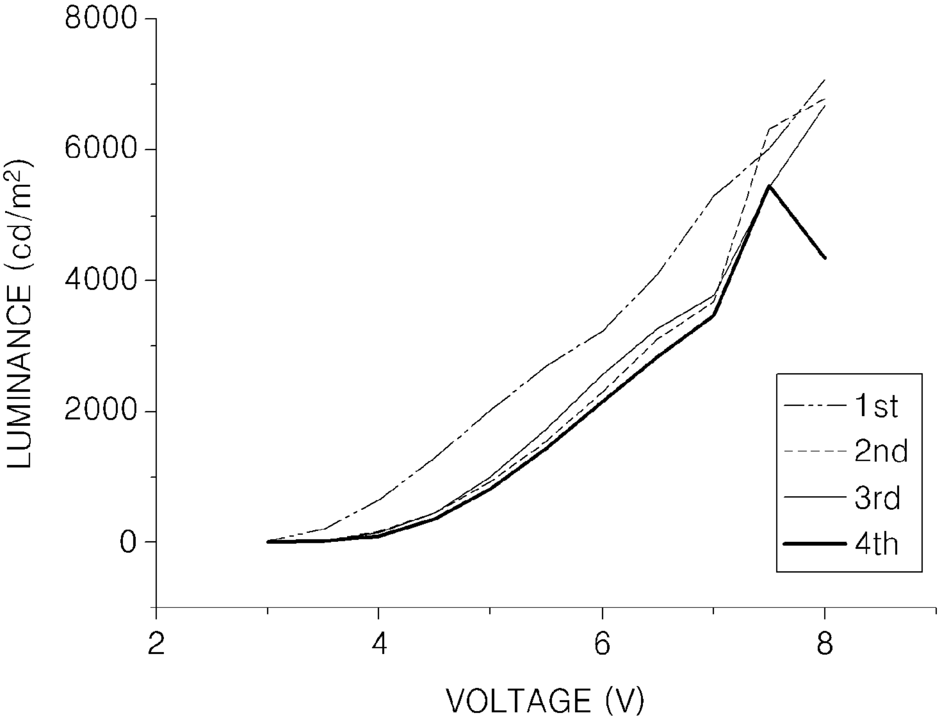
8000
6000
4000
2000
0
LUMINANCE (cd/m2)
2
4
6
8
VOLTAGE (V)
1st
2nd
3rd
4th

FIG. 7

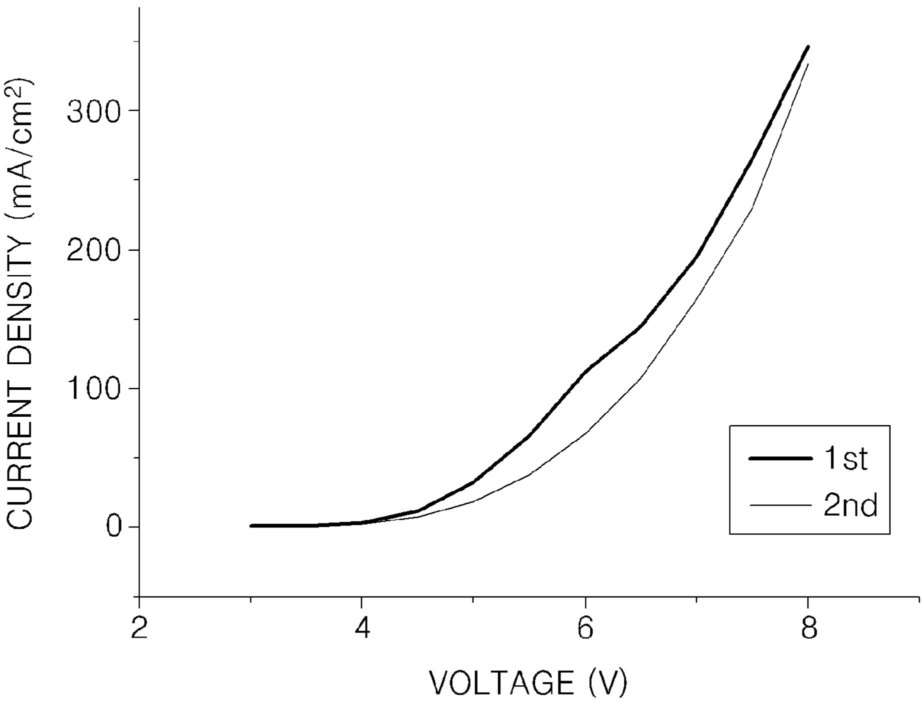

FIG. 8

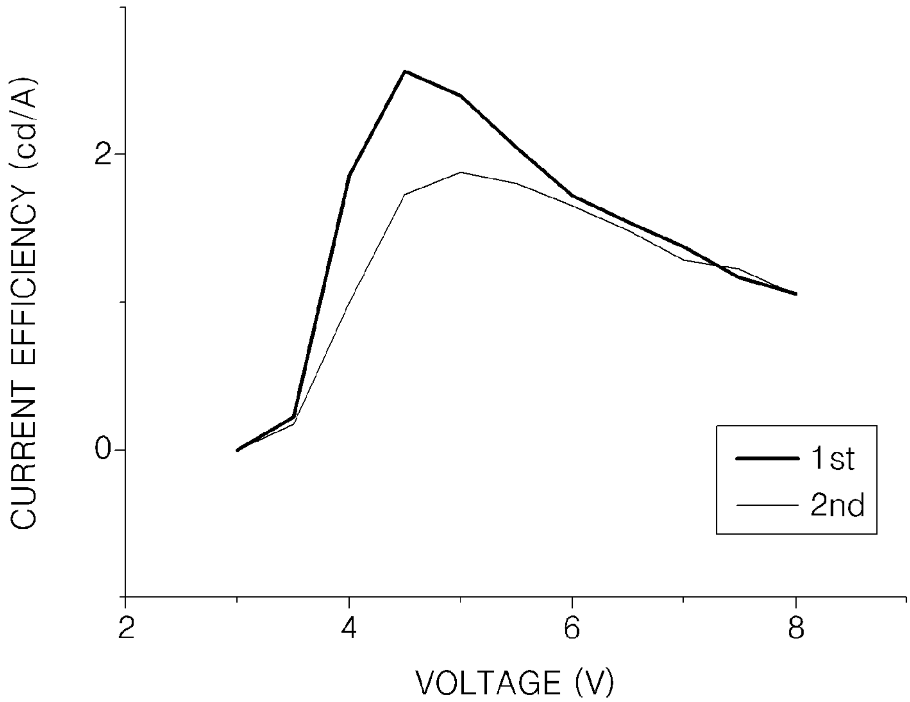

FIG. 9

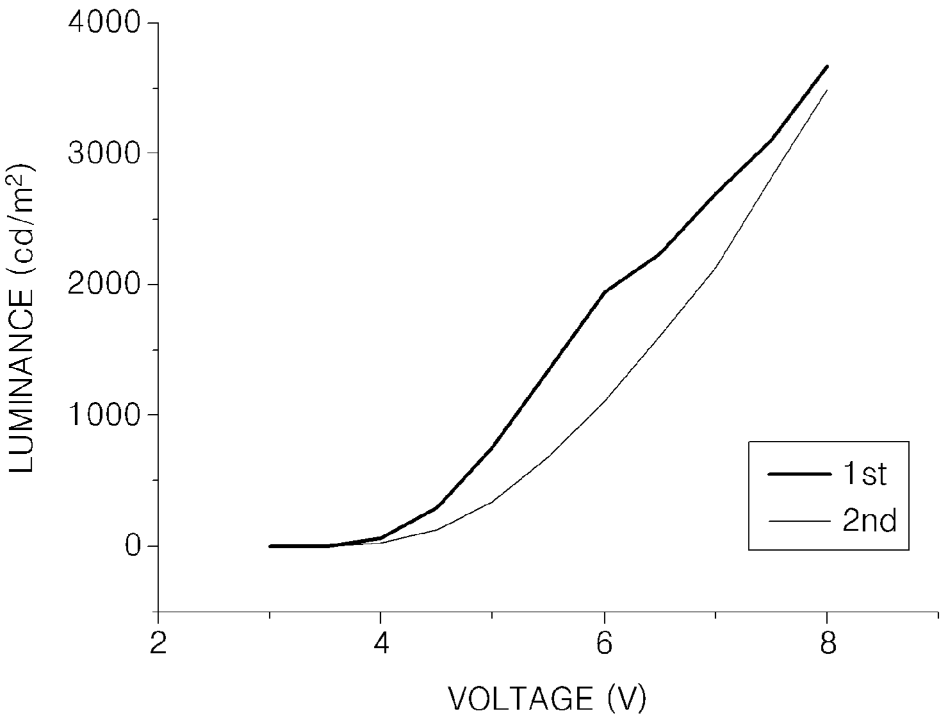

FIG. 10

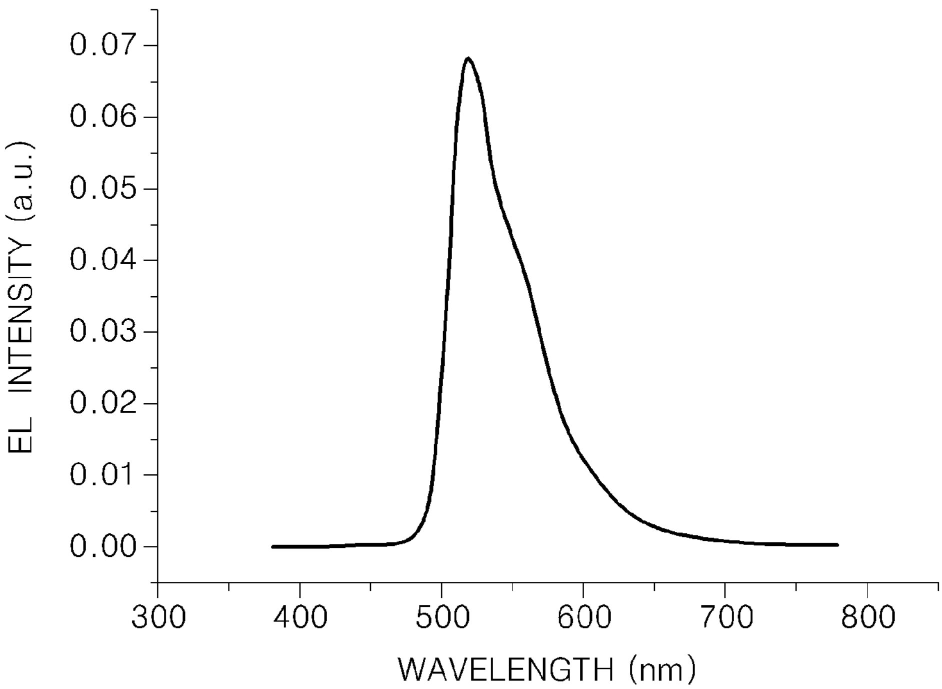
0.07
0.06
0.05
0.04
0.03
0.02
0.01
0.00
EL INTENSITY (a.u.)
300
400
500
600
700
800
WAVELENGTH (nm)

FIG. 11

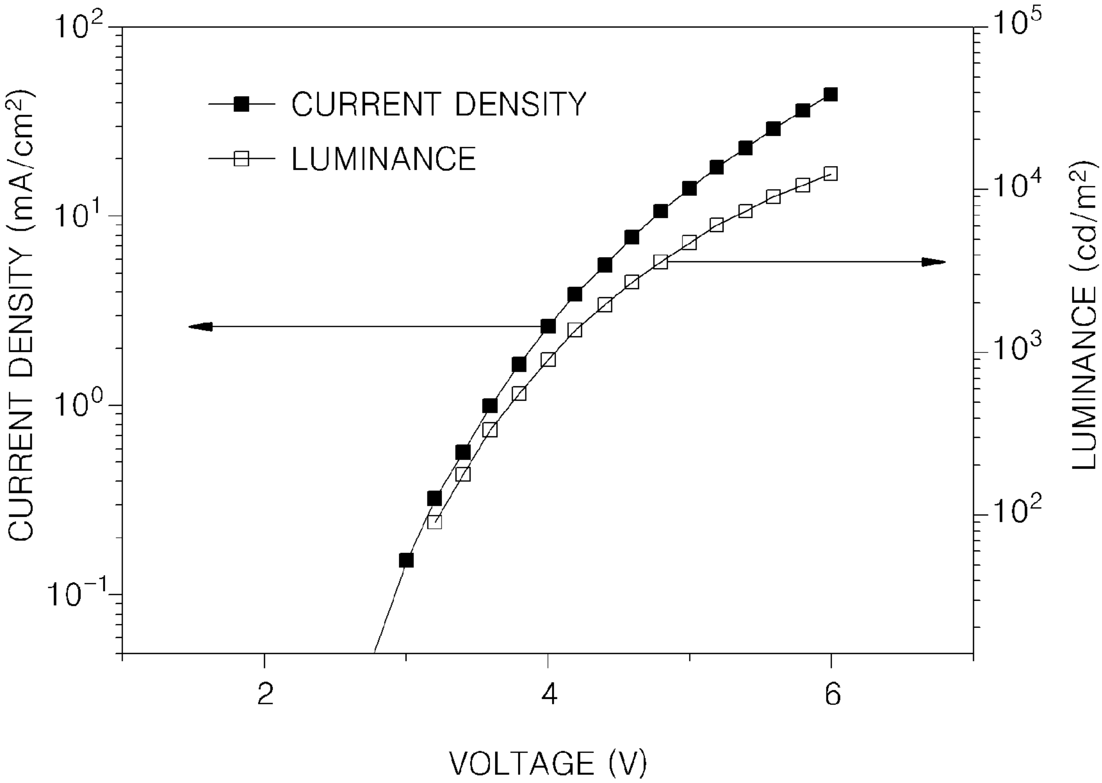

$10^2$
$10^1$
$10^0$
$10^{-1}$
CURRENT DENSITY (mA/cm$^2$)
CURRENT DENSITY
LUMINANCE
$10^5$
$10^4$
$10^3$
$10^2$
LUMINANCE (cd/m$^2$)
2
4
6
VOLTAGE (V)

FIG. 12

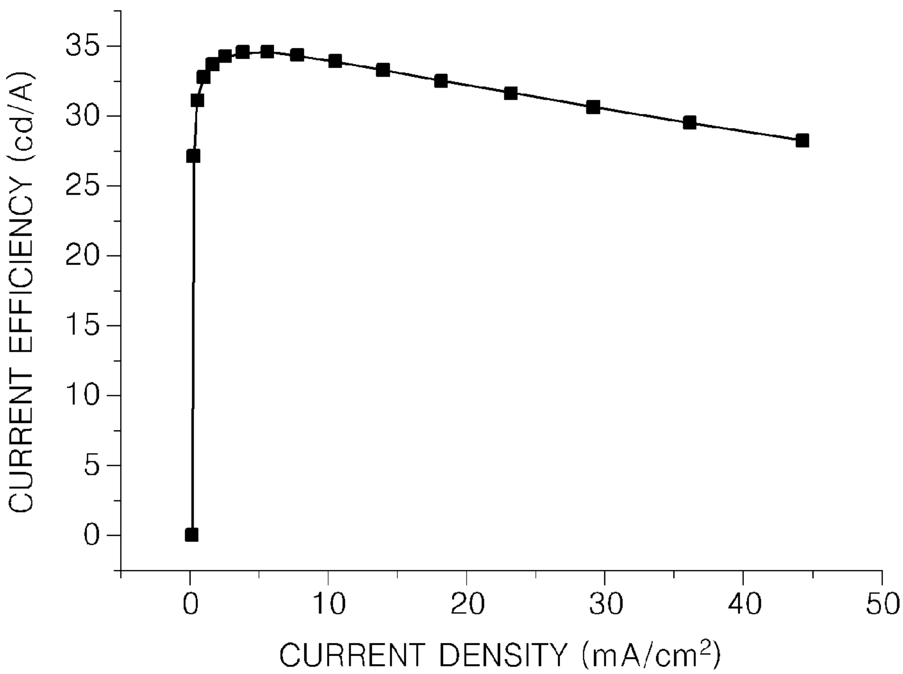
CURRENT EFFICIENCY (cd/A)
35
30
25
20
15
10
5
0
0
10
20
30
40
50
CURRENT DENSITY (mA/cm2)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20070173633 A